# EUROPEAN PATENT APPLICATION

(11) **EP 1 679 627 A1**
(43) Date of publication of application: **12.07.2006**
(21) Application number: 03770083.8
(22) Date of filing: 31.10.2003
(51) Int. Cl.: G06F 17/50

(54) **VERIFICATION SUPPORT DEVICE, VERIFICATION SUPPORT METHOD, VERIFICATION SUPPORT PROGRAM, AND RECORDING MEDIUM**

(71) Applicant: FUJITSU LIMITED, Kawasaki-shi, Kanagawa 211-8588 (JP)
(72) Inventor: SHOJI, Minoru,c/o Fujitsu Limited, Kawasaki-shi, Kanagawa 211-8588 (JP)
(74) Representative: Fenlon, Christine Lesley
(86) International application number: PCT/JP2003/013995
(87) International publication number: WO 2005/043419

(57) **Abstract**

In a verification support apparatus (1500), an input unit (1502) accepts input of an unverified specification description representing an unverified design object constituted by unverified model elements. A searching unit (1503) searches, from verified specification descriptions representing verified design objects constituted by verified model elements, a verified specification description identical or similar to the unverified specification description input to the input unit (1502) based on the unverified model elements and the verified model elements. A logic-verification-content extracting unit (1504) extracts contents of logic verification performed on the verified design object, based on a result of search by the searching unit (1503). An output unit outputs the contents of the logic verification extracted by the logic-verification-content extracting unit (1504).

## Description

### TECHNICAL FIELD

The present invention relates to a verification support apparatus, a verification support method, a verification support program, and a recording medium that stores the program for supporting logic verification in large-scale integration (LSI) design.

### BACKGROUND ART

In LSI design, when logic verification is performed for a design target system constituted by hardware or software, generally, an experienced worker such as a leader of each section estimates a logic verification method, data and environments needed for the logic verification, and procurement (development, purchase, and installation) costs thereof based on experience, and a logic verification plan is determined according to the estimation.

While it is essential to perform the logic verification operation verifying whether LSI operates properly and this logic verification is important to maintain a high quality especially for an LSI required to have a large scale, a multifunction, a high speed, and low power consumption, higher efficiency in the operation by reducing a design period have been demanded. As LSI is made to have a large scale, a multifunction, a high speed, and low power consumption, types and scale of a system to be a design target increases. Therefore, it is problematic that cost of the logic verification increases as a whole. As the cost spent on the logic verification increases, it is problematic that the risk increases when the costs of the logic verification are different from the estimation of the experiment worker. Therefore, in LSI design, when the cost of the logic verification is increased and the associated risk is generated, corresponding costs may be added to a product price and it is problematic that the price of LSI becomes higher compared to a case in which no increase in the cost of the logic verification occurs or no risk is generated.

To avoid this situation as much as possible, it may be considered to find out information on the logic verification, such as how much work of logic verification and how much cost are needed, from a great deal of experience in accordance with specifications of each design target system to perform an operation for keeping the estimation error at a minimum. However, when trying to perform such an operation, since a burden of a designer is increased and the logic verification operation is disturbed, a labor amount is increased as a result, and it is problematic that the logic verification operation is prolonged.

Generally, the information on the past logic verification is stored in each section. Therefore, if logic verification of the system designed in one section is identical or similar to the past logic verification performed in the other section, the information on the logic verification in the other section cannot be diverted by a designer of the one section since it is very difficult to find the information. Thus, it is problematic that the information on the logic verification cannot be shared between the sections.

In view of the above problems, it is an object of the present invention to provide a verification support apparatus, a verification support method, a verification support program, and a recording medium that records the program for achieving reduction of the cost and operation time of the logic verification operation.

### DISCLOSURE OF INVENTION

To solve the above problems and to achieve the object, a verification support apparatus, a verification support method, and a verification support program of the present invention includes an input unit configured to accept input of an unverified specification description representing an unverified design object constituted by unverified model elements; a searching unit configured to search, from verified specification descriptions representing verified design objects constituted by verified model elements, a verified specification description identical or similar to the unverified specification description input to the input unit, based on the unverified model elements and the verified model elements; a logic-verification-content extracting unit configured to extract contents of logic verification performed on the verified design object, based on a result of search by the searching unit; and an output unit configured to output the contents of the logic verification extracted by the logic-verification-content extracting unit.

According to the invention, it is possible to identify a verified design object that is designed in accordance with specification description approximate to specification description of the unverified design object. Therefore, contents of logic verification performed on the verified design object can be obtained.

Moreover, while extracting the unverified model elements, extracting the verified model elements, and calculating a similarity between extracted unverified model element and extracted verified model element, the contents of the logic verification performed on the verified design object may be extracted based on calculated similarity.

According to the invention, by calculating the similarity between the unverified model element and the verified model element, it is possible to calculate a similarity between the unverified specification description and the verified specification description.

Furthermore, while comparing a text expressing the extracted unverified model element and a text expressing the extracted verified model element, and calculating a score representing the similarity based on a result of comparison, the contents of the logic verification performed on the verified design object may be extracted based on calculated score.

According to the invention, by comparing the text expressing the unverified model element and the text expressing the verified model element, it is possible to express the similarity numerically by the score. Therefore, the similarity between the unverified specification description and the verified specification description can be objectively comprehended.

Moreover, while disassembling each of the text expressing the unverified model element extracted by the unverified-model-element extracting unit and the text expressing the verified model element extracted by the verified-model-element extracting unit into words, the extracted text expressing the unverified model element and the extracted text expressing the verified model element may be compared based on the words obtained by disassembling.

According to the invention, by comparing the words constituting the text expressing the unverified model element and the words constituting the text expressing the verified model element, it is possible to express the similarity numerically by the score in more detail. Therefore, the similarity between the unverified specification description and the verified specification description can be comprehended objectively in an effective manner.

Furthermore, while weighting the words obtained by disassembling the text expressing the unverified model element, wherein the score representing the similarity between the unverified model element and the verified model element may be calculated based on the result of comparison and the weight of the word. According to the invention, the verified specification description including a word with a higher importance level can be preferentially searched.

Moreover, the unverified specification description representing the unverified design object and the verified specification description representing the verified design object are described in a unified modeling language (UML). According to the invention, the verified specification description identical or similar to the unverified specification description can be searched from the viewpoints of a function, an interaction, a state change, a process, and a physical structure.

Furthermore, the contents of the logic verification may include at least any one of a logic verification policy, an item of the logic verification, a logic verification method, information on cost required for the logic verification, and a tool used when the logic verification is performed on the verified design object. According to the invention, a specific example of the contents of the logic verification can be provided to a designer.

### BRIEF DESCRIPTION OF DRAWINGS

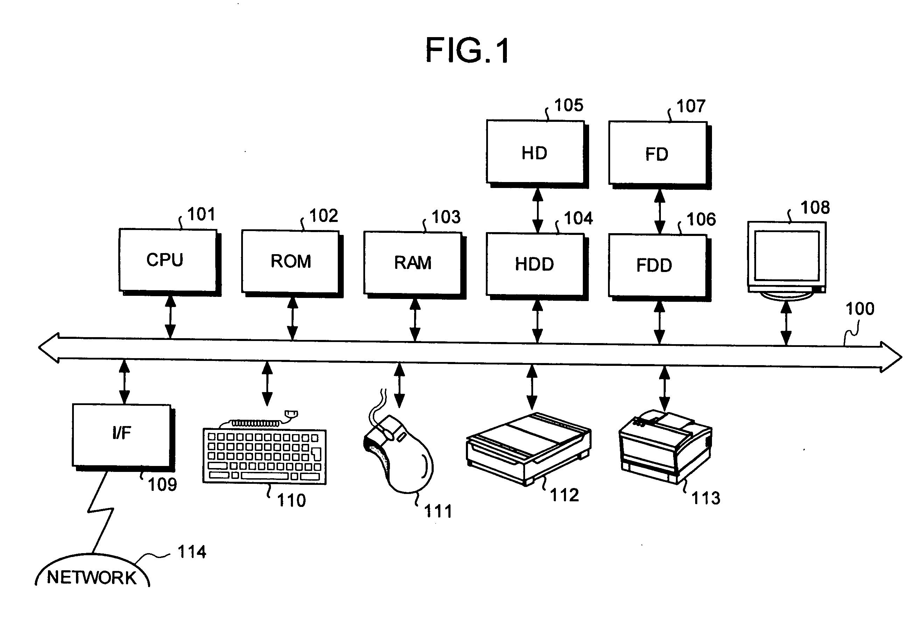

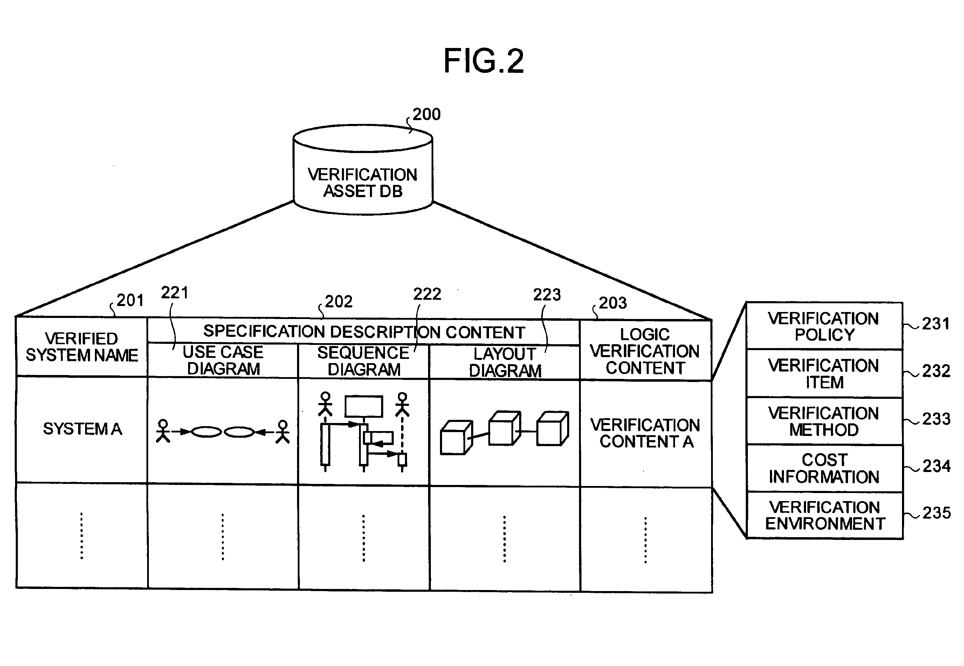

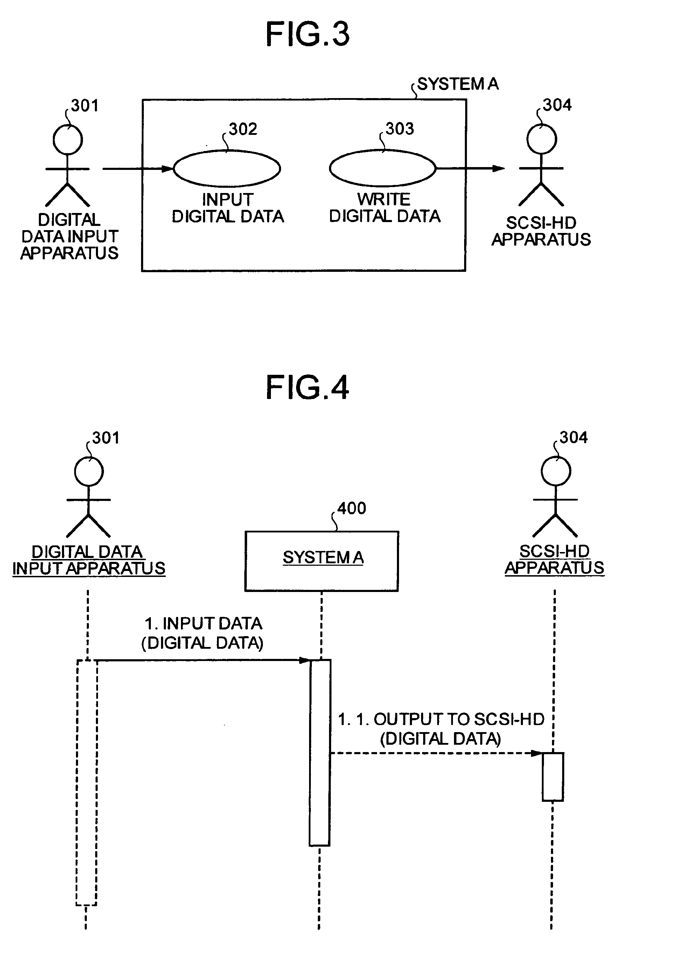

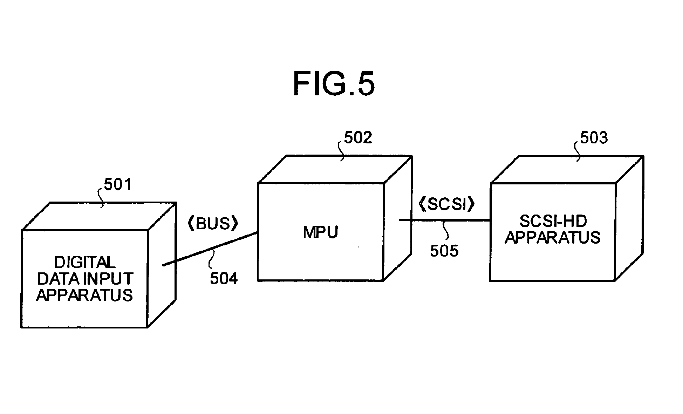

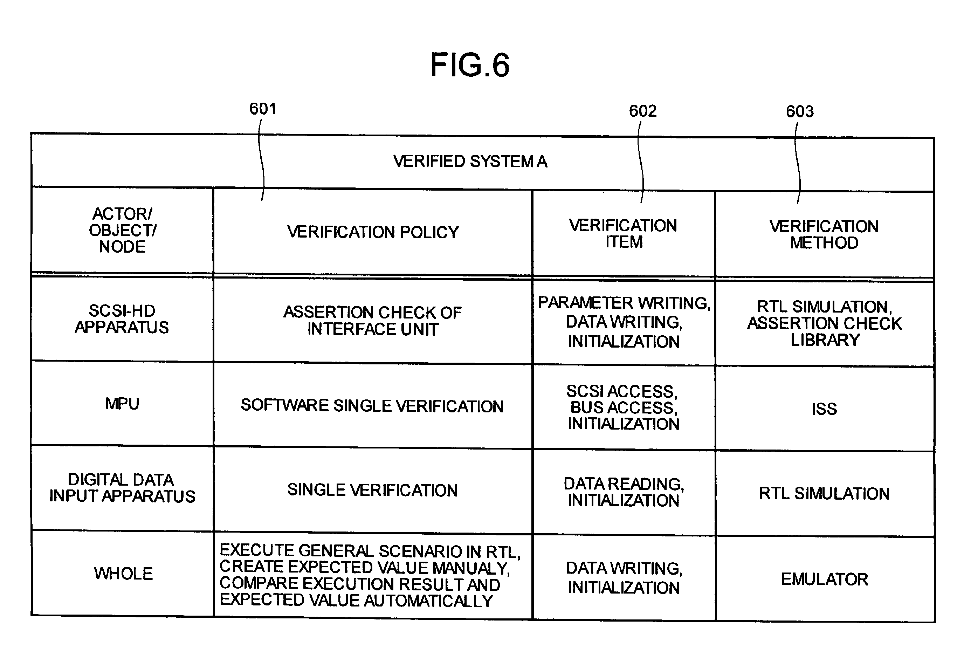

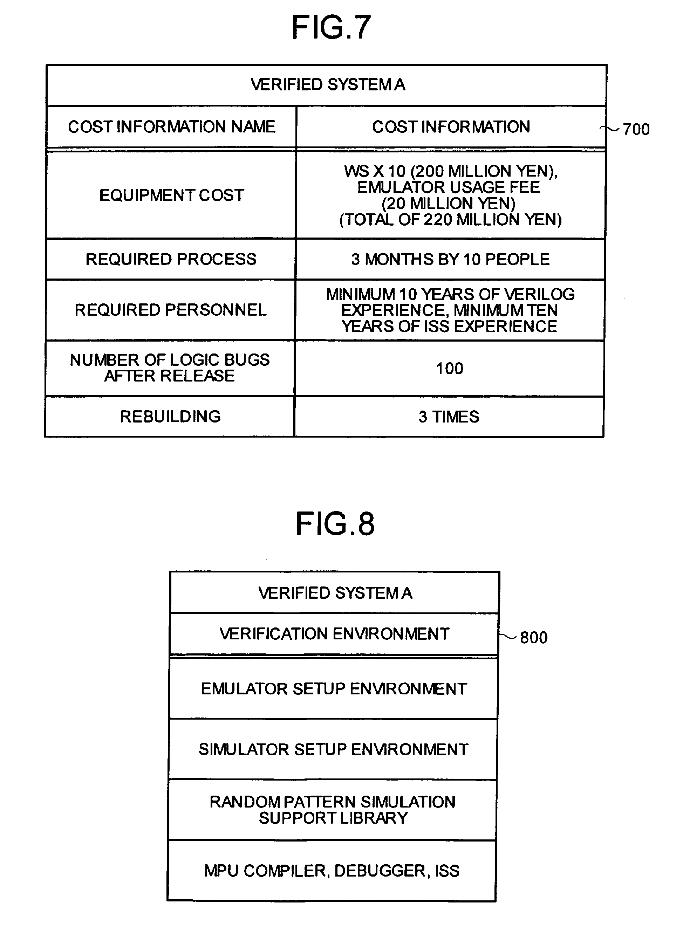

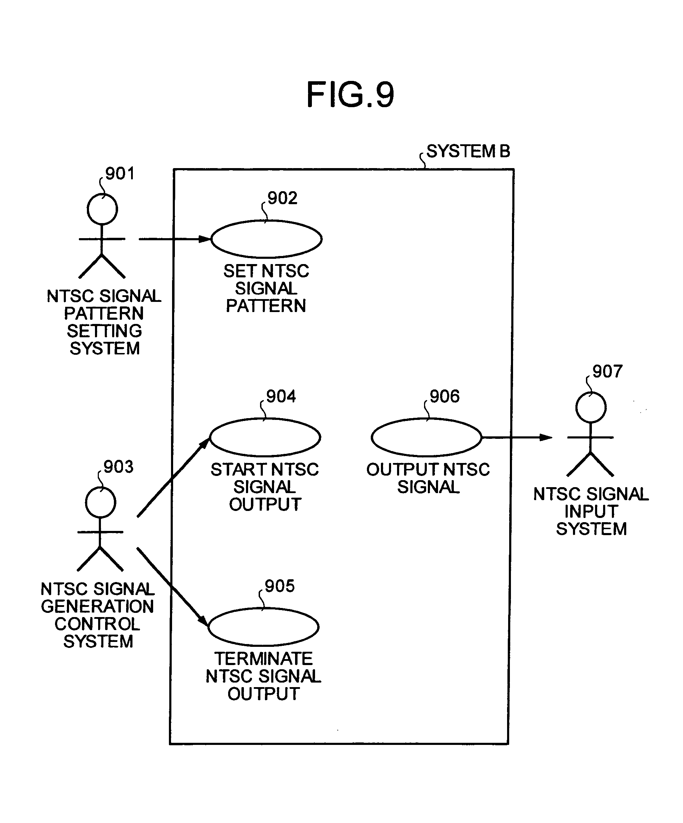

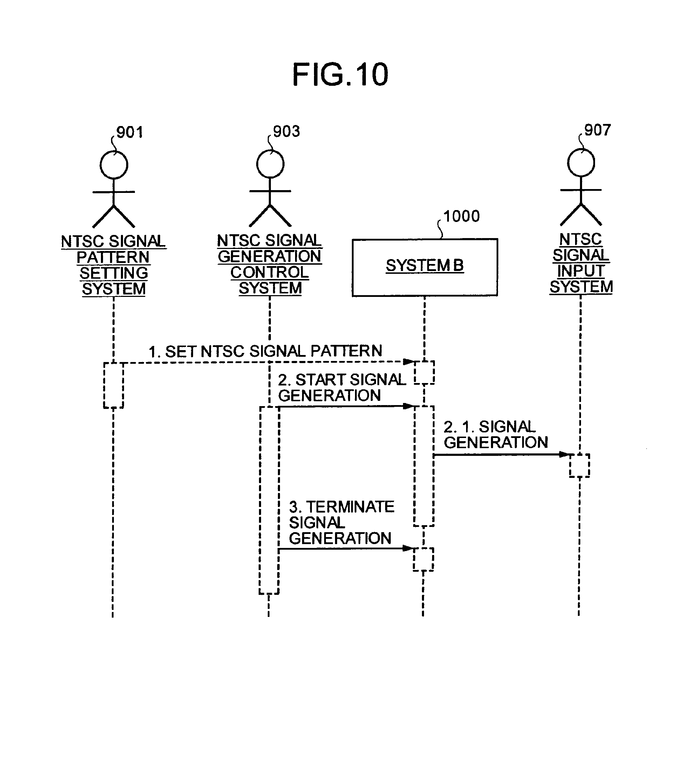

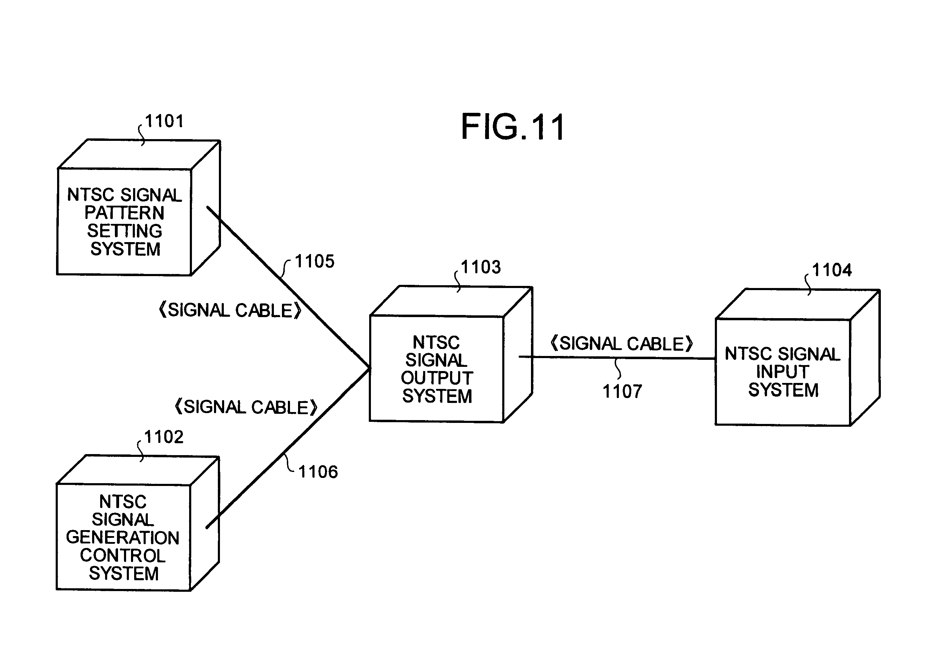

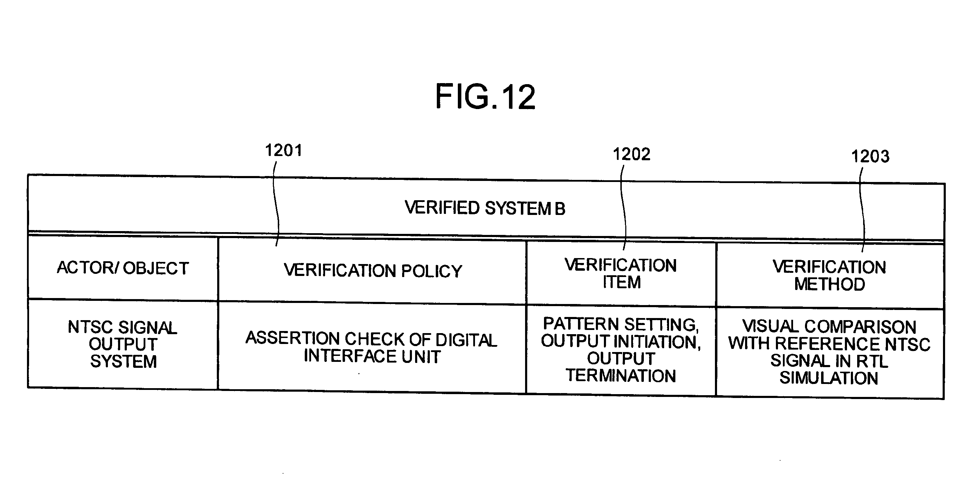

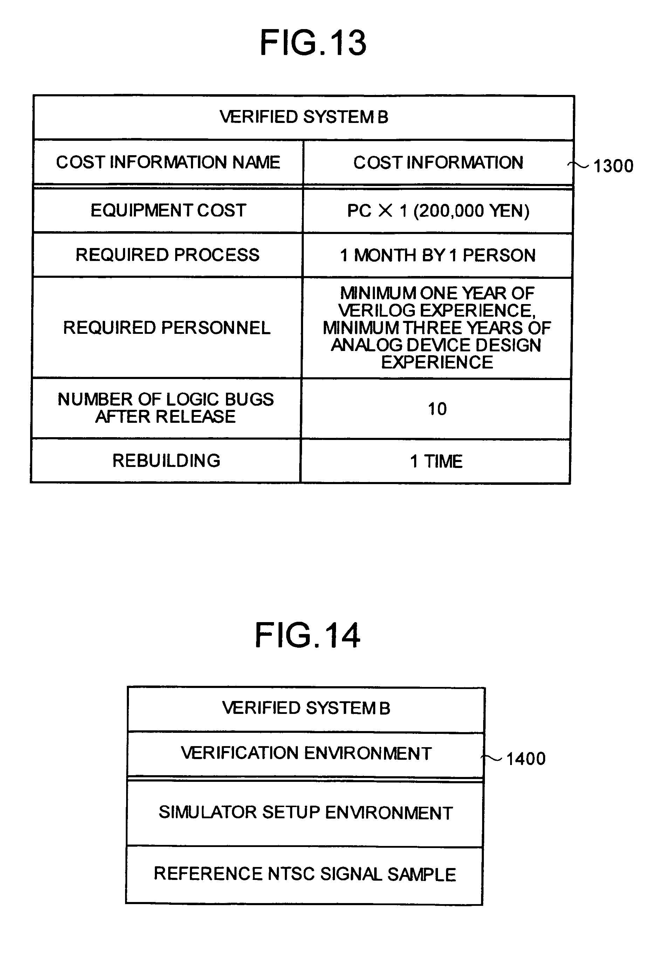

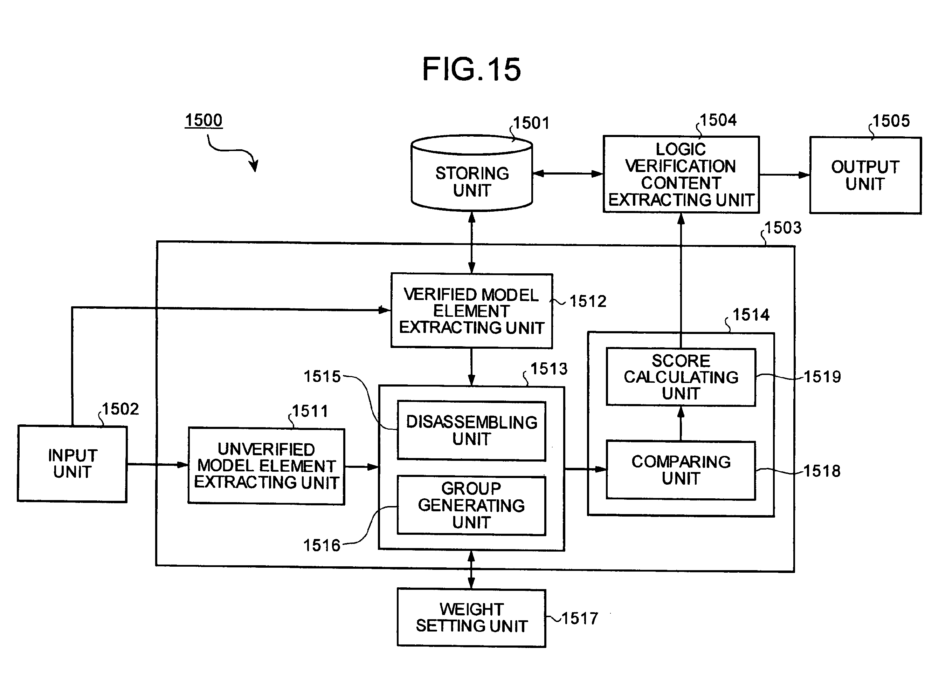

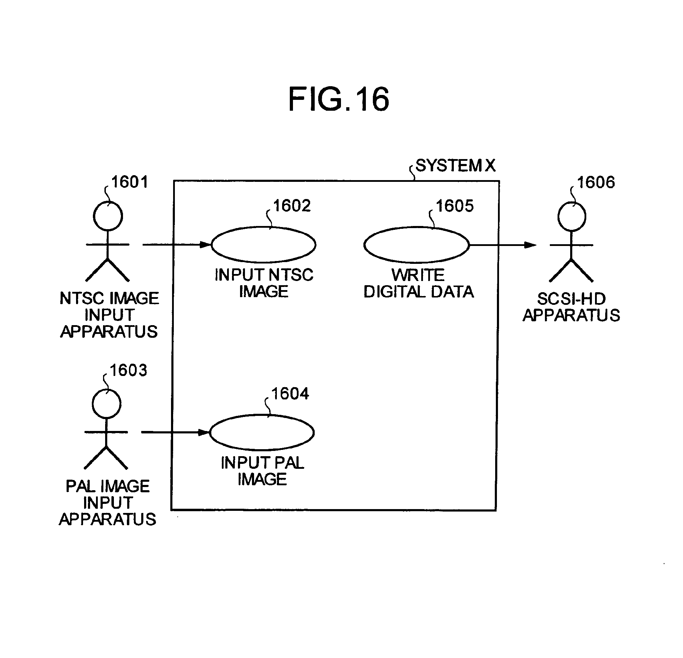

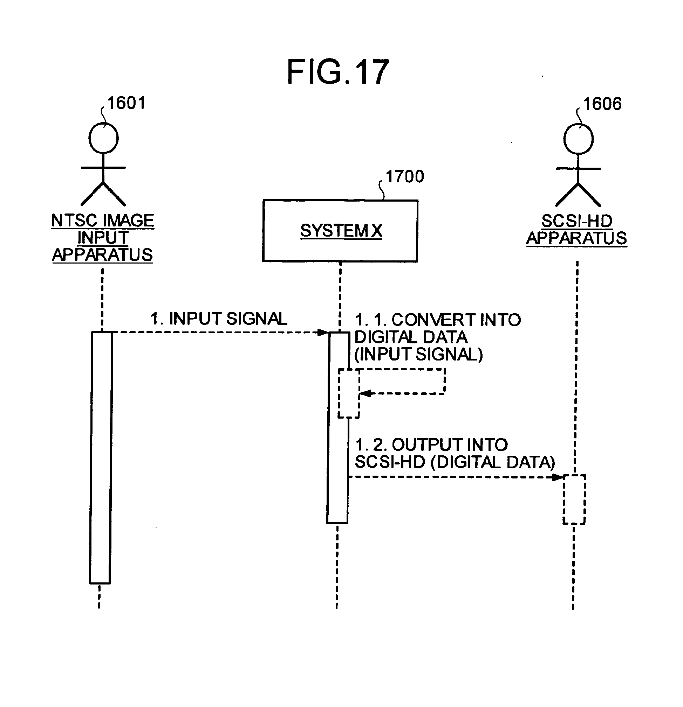

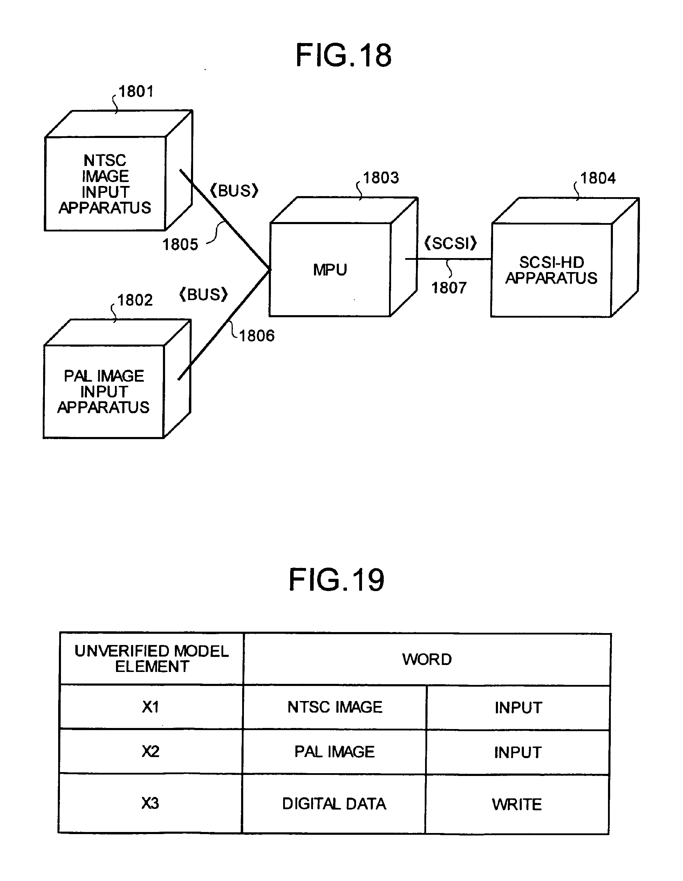

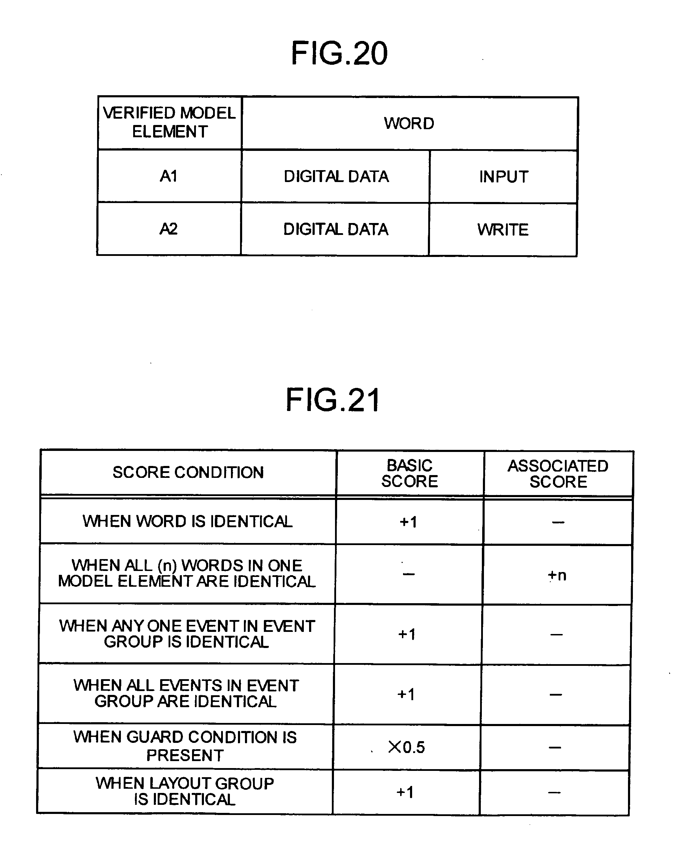

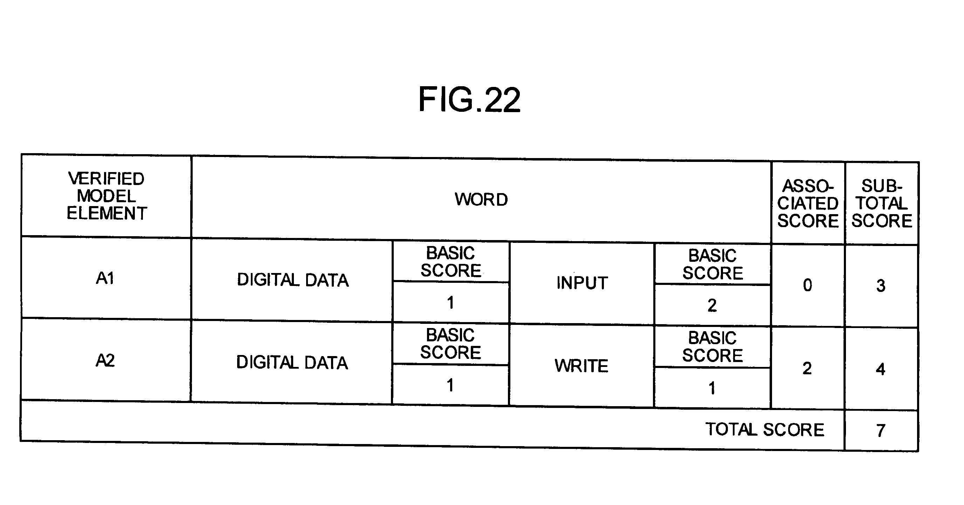

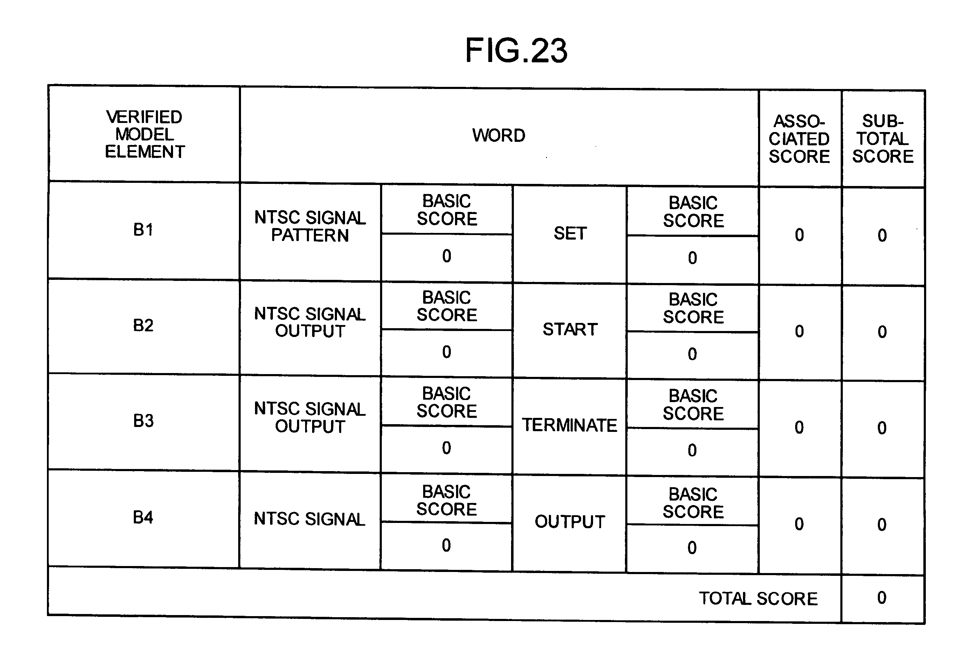

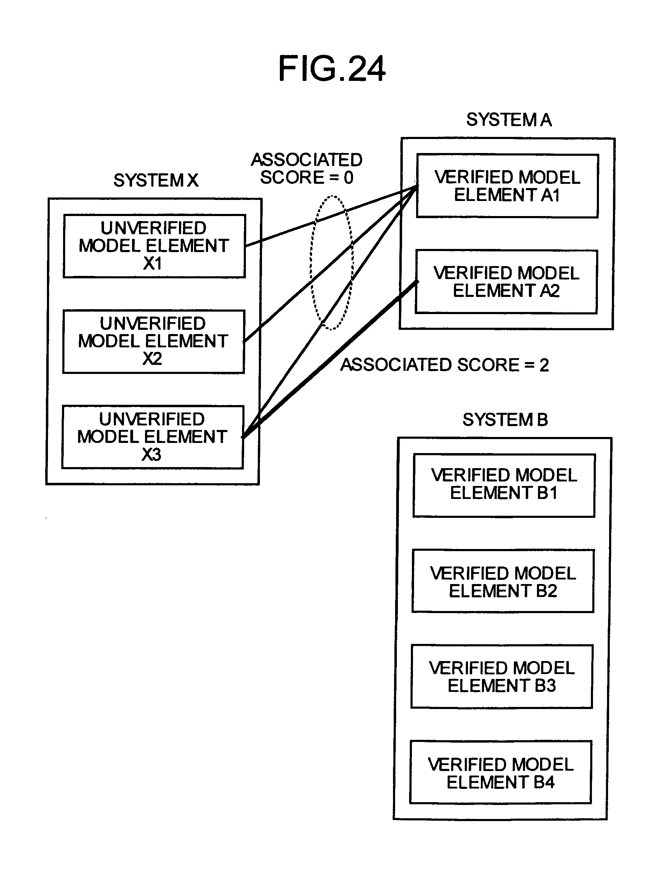

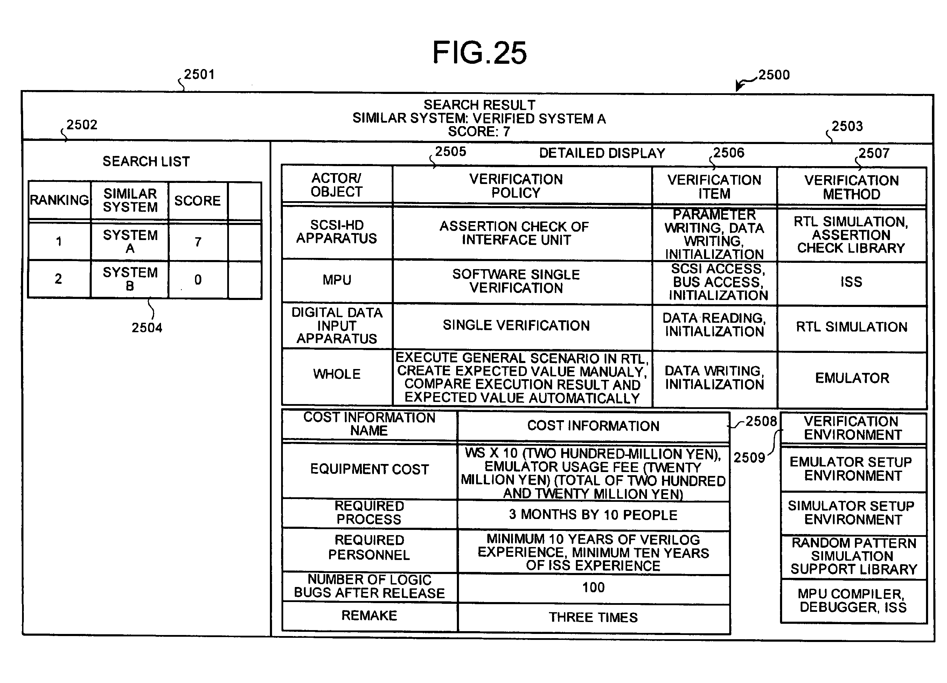

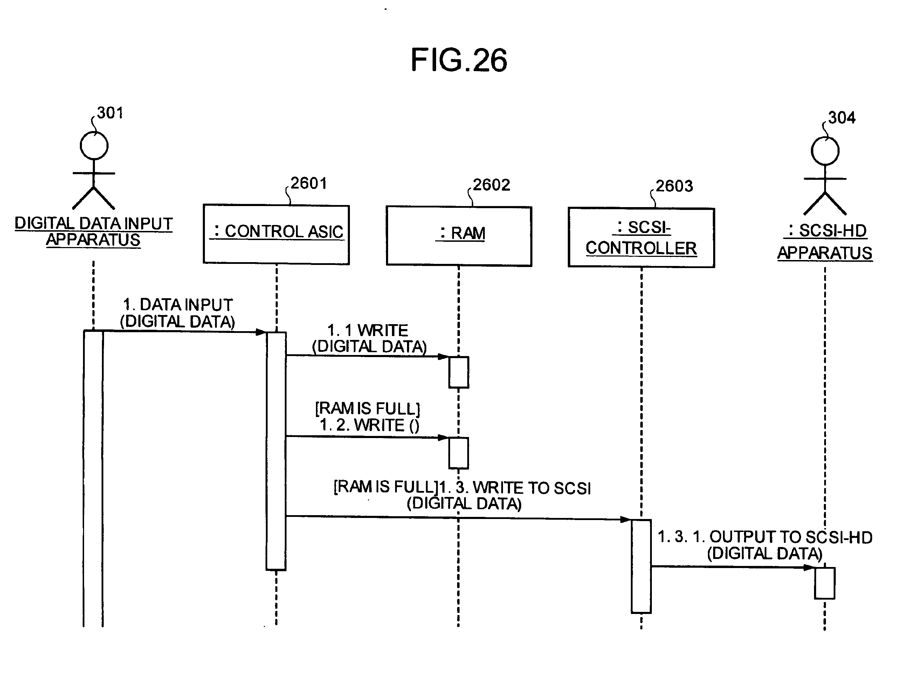

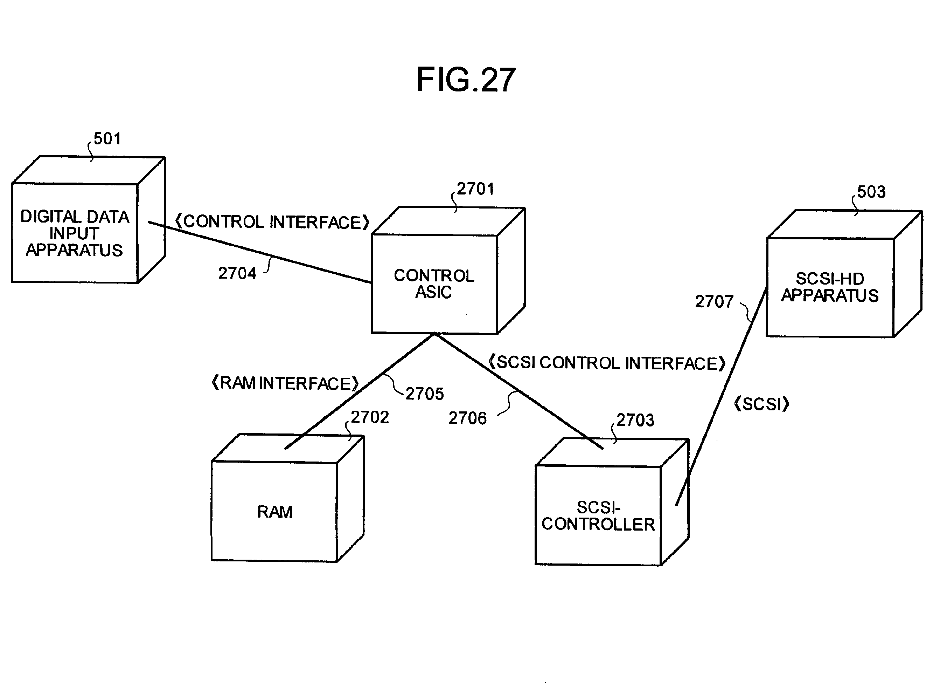

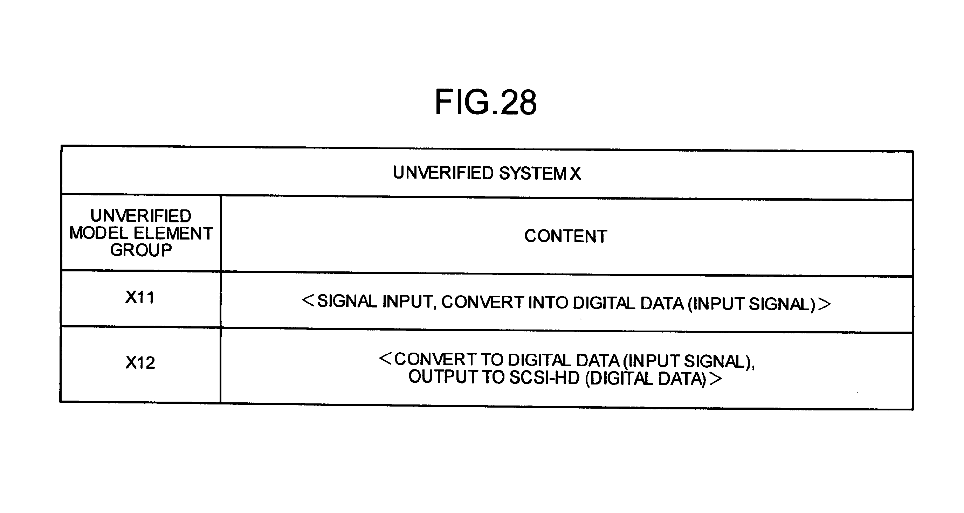

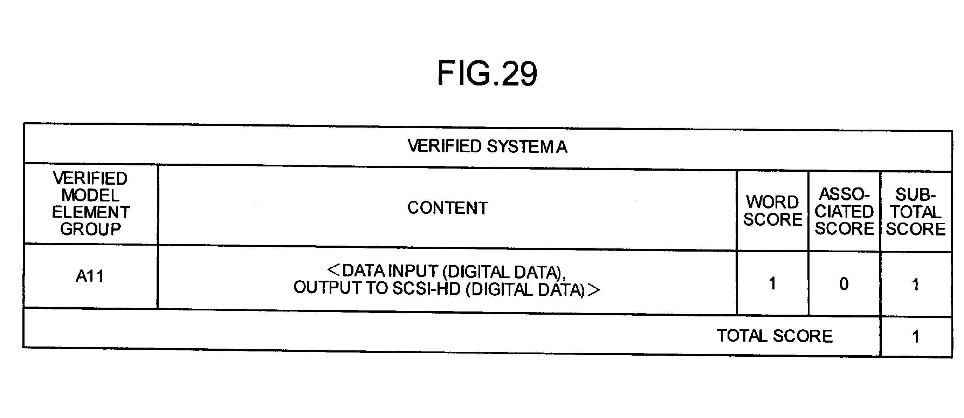

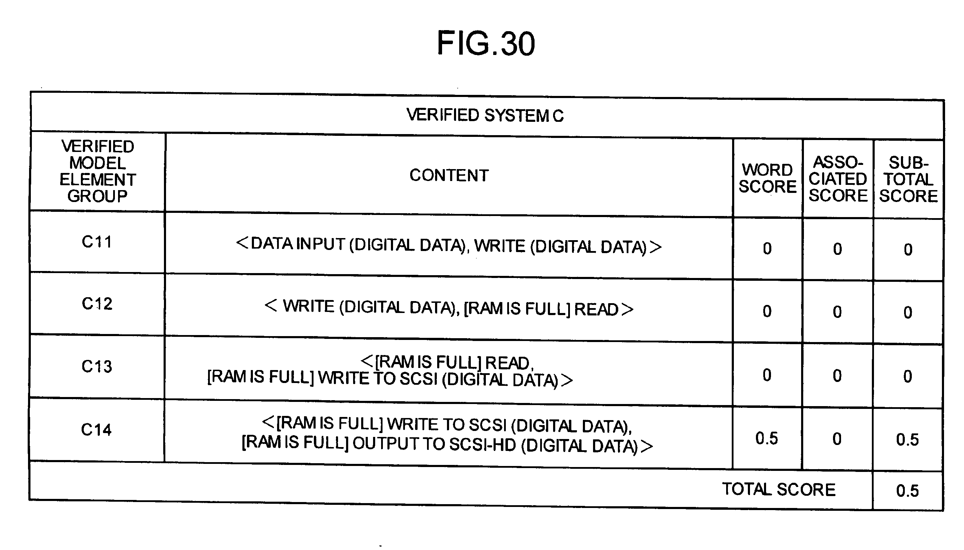

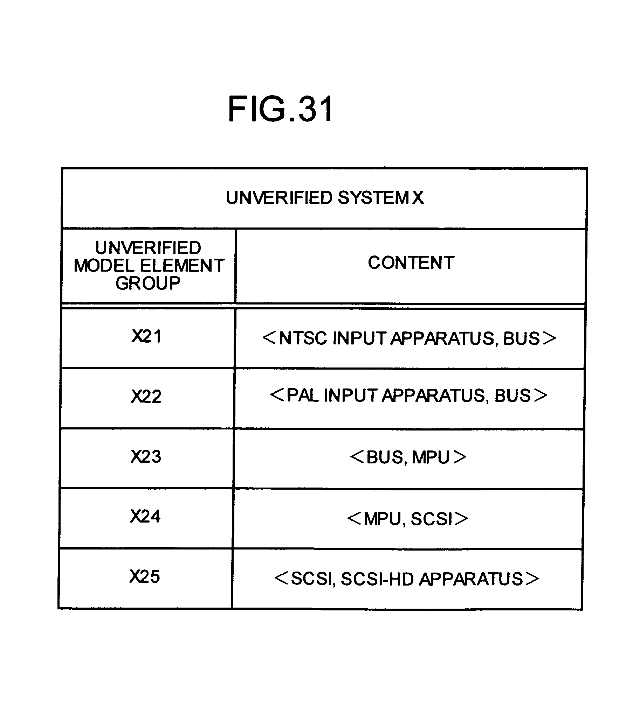

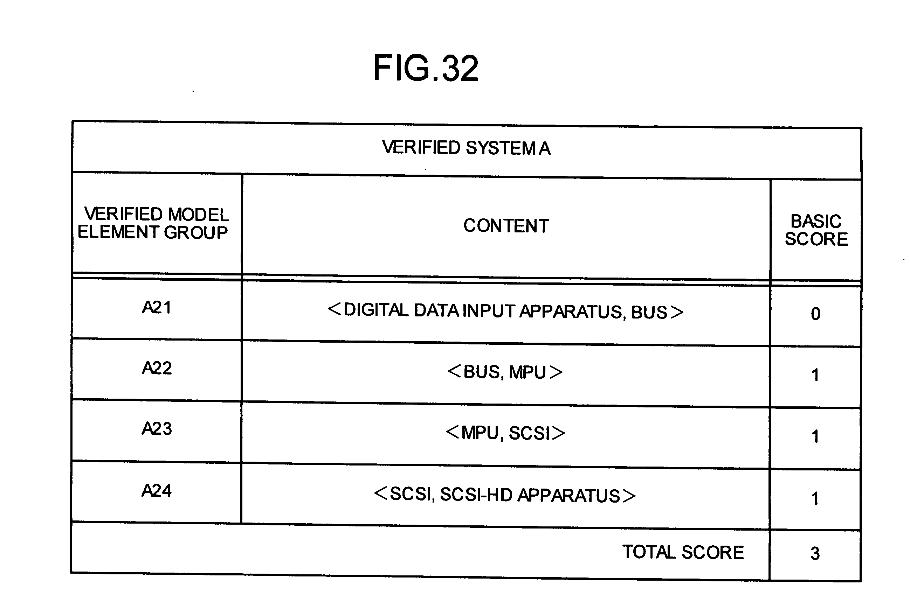

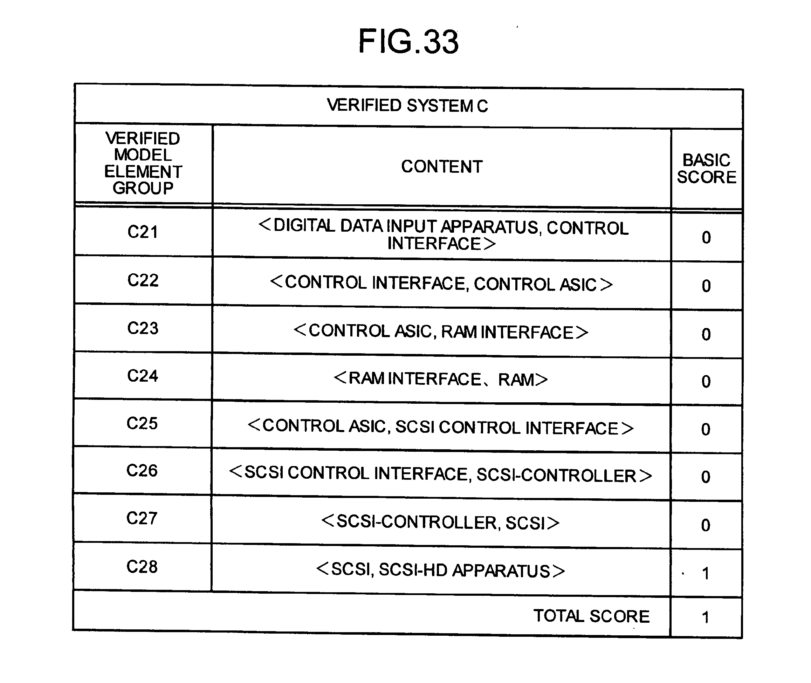

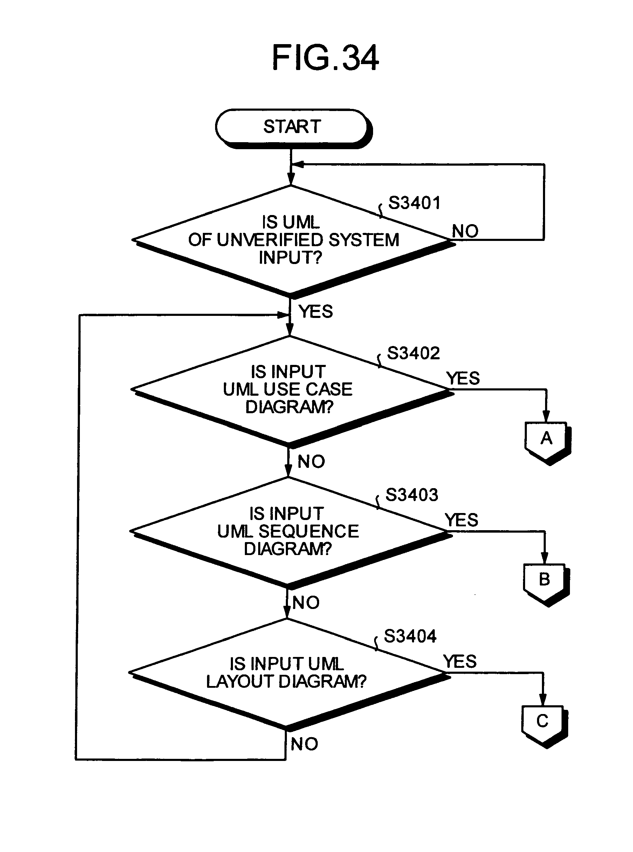

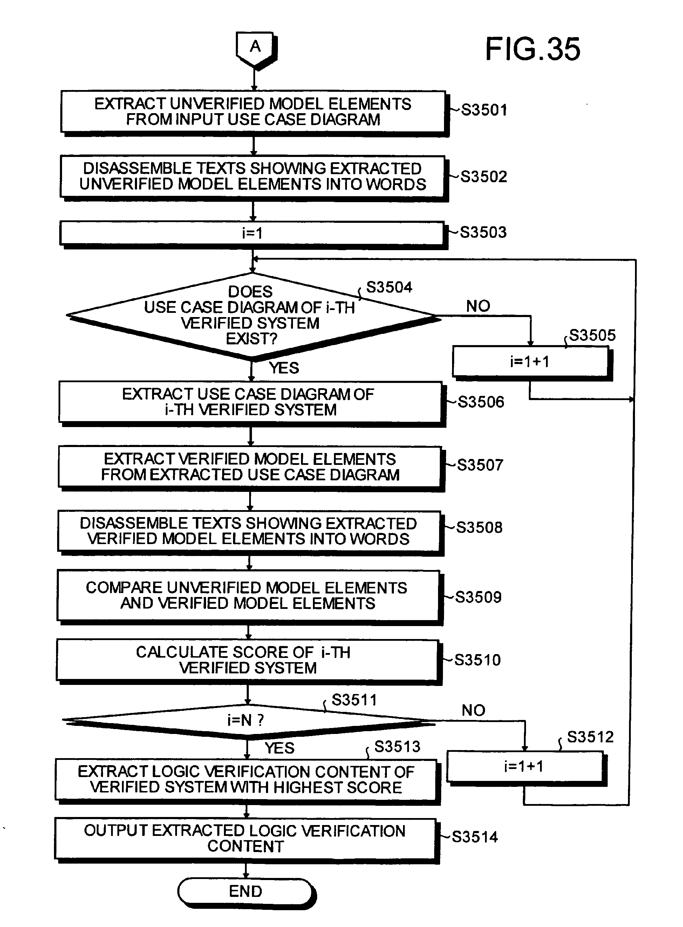

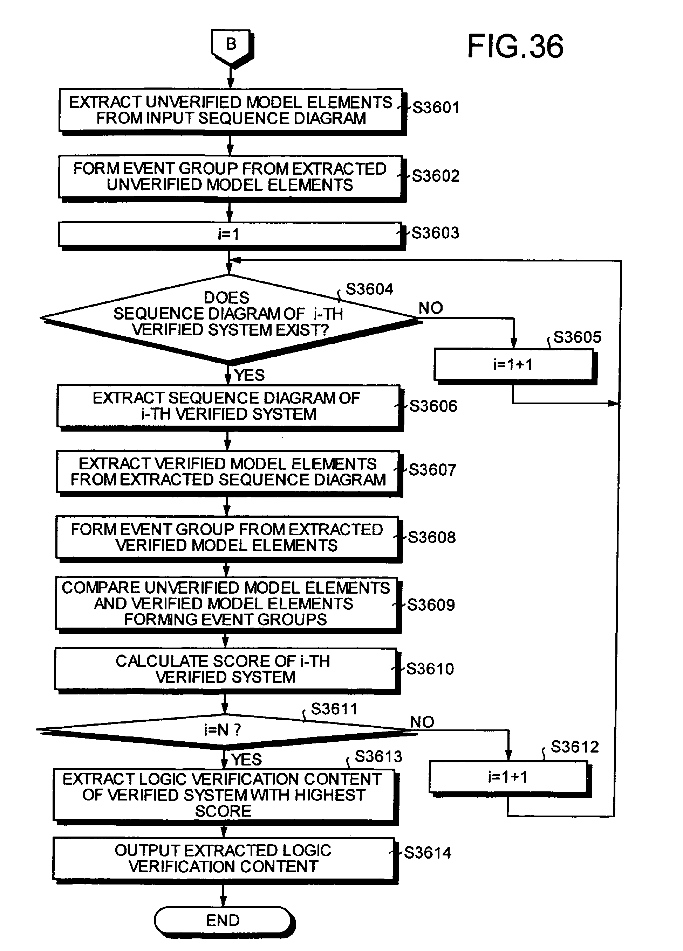

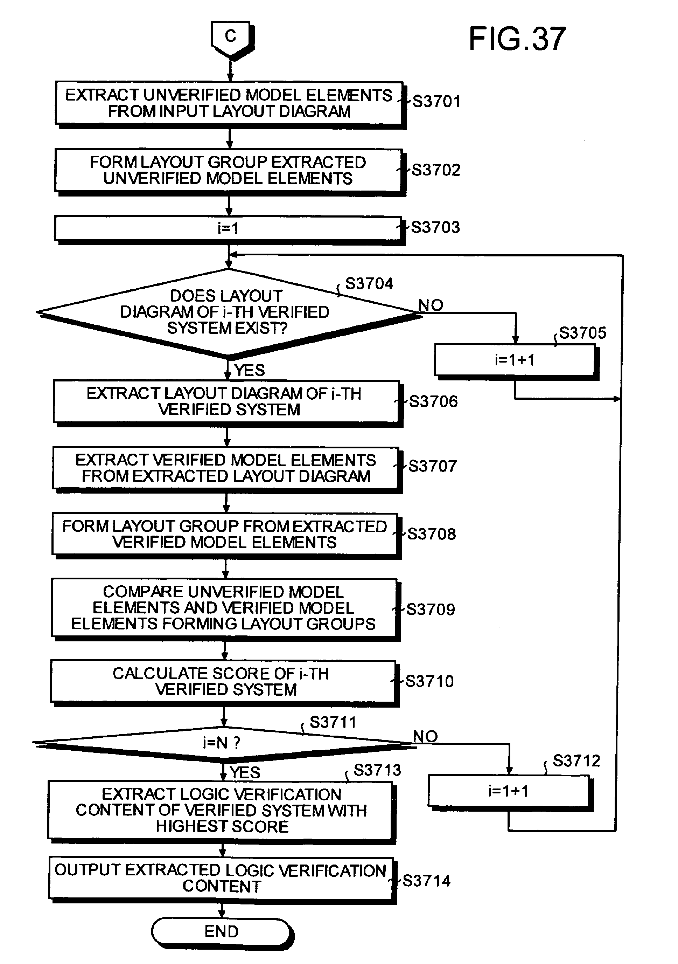

Fig. 1 is a block diagram showing a hardware configuration of a verification support apparatus according to an embodiment of the present invention; Fig. 2 is an explanatory diagram showing storage content of a verification asset database according to the embodiment of the present invention; Fig. 3 is a use case diagram of a verified system A; Fig. 4 is a sequence diagram of the verified system A; Fig. 5 is a layout diagram of the verified system A; Fig. 6 is an explanatory diagram showing verification policies, verification items, and verification methods of the verified system A; Fig. 7 is an explanatory diagram showing cost information of the verified system A; Fig. 8 is an explanatory diagram showing a verification environment of the verified system A; Fig. 9 is a use case diagram of a verified system B; Fig. 10 is a sequence diagram of the verified system B; Fig. 11 is a layout diagram of the verified system B; Fig. 12 is an explanatory diagram showing a verification policy, verification items, and verification method of the verified system B; Fig. 13 is an explanatory diagram showing cost information of the verified system B; Fig. 14 is an explanatory diagram showing a verification environment of the verified system B; Fig. 15 is a block diagram showing a functional configuration of the verification support apparatus according to the embodiment of the present invention; Fig. 16 is a use case diagram of an unverified system X; Fig. 17 is a sequence diagram of the unverified system X; Fig. 18 is a layout diagram of the unverified system X; Fig. 19 is an explanatory diagram showing an example of disassembling texts showing unverified model elements; Fig. 20 is an explanatory diagram showing an example of disassembling texts showing verified model elements; Fig. 21 is a chart showing a relationship between score conditions when words are compared and basic scores and associated scores in those cases; Fig. 22 is an explanatory diagram showing a relationship between the verified system A compared with the unverified system X and the scores; Fig. 23 is an explanatory diagram showing a relationship between the verified system B compared with the unverified system X and the scores; Fig. 24 is an explanatory diagram showing a relationship between the unverified system X and the verified systems A and B; Fig. 25 is an explanatory diagram showing a search-result display example according to the embodiment of the verification support apparatus of the present invention; Fig. 26 is a sequence diagram of a verified system C; Fig. 27 is a layout diagram of the verified system C; Fig. 28 is an explanatory diagram showing a verified event group of the unverified system X when the specification description of the unverified system X is sequence diagram in UML; Fig. 29 is an explanatory diagram showing a relationship with a verified model element of the verified system A and the score thereof; Fig. 30 is an explanatory diagram showing a relationship with verified model elements of the verified system C and the scores thereof; Fig. 31 is an explanatory diagram showing a verified model element group of the unverified system X when the specification description of the unverified system X is a layout diagram in UML; Fig. 32 is an explanatory diagram showing a relationship with verified model elements of the verified system A and the scores thereof; Fig. 33 is an explanatory diagram showing a relationship with verified model elements of the verified system C and the scores thereof; Fig. 34 is a flowchart (part 1) showing a verification support processing of the verification support apparatus according to the embodiment of the present invention; Fig. 35 is a flowchart (part 2) showing a verification support processing of the verification support apparatus according to the embodiment of the present invention; Fig. 36 is a flowchart (part 3) showing a verification support processing of the verification support apparatus according to the embodiment of the present invention; and Fig. 37 is a flowchart (part 4) showing a verification support processing of the verification support apparatus according to the embodiment of the present invention.

### BEST MODE(S) FOR CARRYING OUT THE INVENTION

Embodiments of a verification support apparatus, a verification support method, a verification support program, and a recording medium that records the program according to the present invention will be explained in detail below with reference to the drawings.

### (Embodiments)

### (Hardware Configuration of Verification Support Apparatus)

First, description will be made of a hardware configuration of the verification support apparatus according to the embodiment of the present invention. Fig. 1 is a block diagram showing a hardware configuration of the verification support apparatus according to the embodiment of the present invention. As shown in Fig. 1, the verification support apparatus includes a central processing unit (CPU) 101, a read-only memory (ROM) 102, a random-access memory (RAM) 103, a hard disk drive (HDD) 104, a hard disk (HD) 105, a flexible disk drive (FDD) 106, a flexible disk (FD) 107 as an example of a removable recording medium, a display 108, an interface (I/F) 109, a keyboard 110, a mouse 111, a scanner 112, and a printer 113. The components are connected to each other through a bus 100.

The CPU 101 is responsible for overall control of the verification support apparatus. The ROM 102 stores a program such as a boot program. The RAM 103 is used as a work area of the CPU 101. The HDD 104 controls read/write of data from/to the HD 105 under a control of the CPU 101. The HD 105 stores data written under the control of the HDD 104.

The FDD 106 controls read/write of data from/to the FD 107 under a control of the CPU 101. The FD 107 stores data written under a control of the FDD 106 and allows the verification support apparatus to read the data stored in the FD 107.

Besides the FD 107, a removable recording medium may be a compact-disk read-only memory (CD-ROM) (a compact-disk recordable (CD-R), a compact-disk rewritable (CD-RW)), a magneto optical (MO) disk, a digital versatile disk (DVD), and a memory card. The display 108 displays a cursor, icons or tool boxes as well as data such as a document, an image, and function information. This display 108 may be, for example, a cathode ray tube (CRT), a thin film transistor (TFT) liquid crystal display, a plasma display, etc.

The I/F 109 is connected via a communication line to a network 114 such as the internet and is connected to other apparatuses via this network 114. The I/F 109 is responsible for interfacing the network 114 with the inside of the apparatus and controls input/output of data from/to an external apparatus. The I/F 109 may be, for example, a modem, a local area network (LAN) adaptor, etc.

The keyboard 110 is provided with keys for entering characters, numeric characters, various instructions, etc. to enter data. A touch-panel input pad, a numeric keypad, etc. may be used instead. The mouse 111 moves a cursor, selects an area or moves and resizes a window, etc. A trackball or a joystick may be used instead, as long as similar functions for a pointing device are provided.

The scanner 112 optically reads an image and captures image data into the verification support apparatus. The scanner 112 may have an OCR function. The printer 113 prints image data and document data. The printer 113 may be, for example, a laser printer or ink-jet printer.

### (Storage Content of Verification Asset Database)

Description will be made of storage content of a verification asset database according to the embodiment of the present invention. Fig. 2 is an explanatory diagram showing the storage content of the verification asset database according to the embodiment of the present invention. As shown in Fig. 2, a verification asset database 200 includes a verified system name 201, a specification description content 202, and a logic verification content 203.

For the specification description, for example, the UML is applied, and the verified system can store diagrams such as a use case diagram 221, a sequence diagram 222, and a layout diagram 223 that are described in the UML. The logic verification content 203 is verification content of logic verification performed on the verified system. In the case of a verified system name "system A", the verification content includes a verification policy 231, a verification item 232, a verification method 233, cost information 234, and a verification environment 235.

Description will be made of the storage content of the verified system named "system A" stored in the verification asset database 200 shown in Fig. 2. Fig. 3 is a use case diagram of the verified system A; Fig. 4 is a sequence diagram of the verified system A; Fig. 5 is a layout diagram of the verified system A; Fig. 6 is an explanatory diagram showing verification policies, verification items, and verification methods of the verified system A; Fig. 7 is an explanatory diagram showing cost information of the verified system A; and Fig. 8 is an explanatory diagram showing a verification environment of the verified system A.

The use case diagram shown in Fig. 3 represents functions of the system A. As shown in Fig. 3, an actor 301 is a verified model element representing a digital data input apparatus, which is an external apparatus, and a use case 302 is a verified model element representing a use case description "input digital data" in the system A. A use case 303 is a verified model element representing a use case description "write digital data" in the system A and an actor 304 is a verified model element representing a small computer system interface (SCSI)-HD apparatus, which is an external apparatus.

The sequence diagram shown in Fig. 4 represents data exchanges in the system A in chronological order. As shown in Fig. 4, at sequence number 1, an event "data input (digital data)", which is a verified model element, is performed by the actor 301 of the digital data input apparatus toward an object 400 of the system A. At sequence number 1.1, an event "output to SCSI-HD (digital data)", which is a verified model element, is performed by the object 400 of the system A toward the actor 304 of the SCSI-HD apparatus.

The layout diagram shown in Fig. 5 represents a physical structure of the system A. As shown in Fig. 5, a node 501 is a verified model element representing the digital data input apparatus; a node 502 is a verified model element representing a micro processing unit (MPU); and a node 503 is a verified model element representing the SCSI-HD apparatus. A link 504 is a verified model element representing a bus connecting the node 501 and the node 502, and a link 505 is a verified model element representing a SCSI connecting the node 502 and the node 503.

Fig. 6 illustrates a verification policy 601, a verification item 602, and a verification method 603 for each configuration of the system A. The verification policy 601 represents what technique should be used to perform logic verification. For example, for the SCSI-HD apparatus, it is defined that "assertion check of interface unit" should be performed. The verification item 602 represents details of verification content. For example, for the MPU, three verification items are listed, which are "SCSI access, BUS access, and initialization". The verification method 603 represents a technique when the logic verification was actually performed. It is described that the logic verification of the digital data input apparatus was performed using a "register transfer level (RTL) simulation".

Fig. 7 illustrates cost information representing costs spent on the logic verification operation of the system A. Cost information 700 includes an equipment cost, the number of process, required manpower, the number of logic bugs detected after release, the number of rebuilding, etc. Fig. 8 illustrates a verification environment 800 when the logic verification operation of the system A was performed. The verification environment 800 indicates tools used when the logic verification was performed on the verified system.

Description will be made of storage content of a verified system named "system B" stored in the verification asset database 200 shown in Fig. 2. Fig. 9 is a use case diagram of the verified system B; Fig. 10 is a sequence diagram of the verified system B; Fig. 11 is a layout diagram of the verified system B; Fig. 12 is an explanatory diagram showing a verification policy, verification items, and a verification method of the verified system B; Fig. 13 is an explanatory diagram showing cost information of the verified system B; and Fig. 14 is an explanatory diagram showing a verification environment of the verified system B.

The use case diagram shown in Fig. 9 represents functions of the verified system B. As shown in Fig. 9, an actor 901 is a verified model element representing an national television standards committee (NTSC) signal pattern setting system, which is an external apparatus, and a use case 902 is a verified model element representing a use case description "set NTSC signal pattern" in the system B. An actor 903 is a verified model element representing an NTSC signal generation control system, which is an external apparatus; a use case 904 is a verified model element representing a use case description "start NTSC signal output" in the system B; and a use case 905 is a verified model element representing a use case description "terminate NTSC signal output" in the system B. A use case 906 is a verified model element representing a use case description "output NTSC signal" in the system B and an actor 907 is a verified model element representing an NTSC signal input system, which is an external apparatus.

The sequence diagram shown in Fig. 10 represents data exchanges in the system B in chronological order. As shown in Fig. 10, at sequence number 1, an event "set NTSC signal pattern", which is a verified model element, is performed by the actor 901 of the NTSC signal pattern setting system toward an object 1000 of the system B. At sequence number 2, an event "start signal generation", which is a verified model element, is performed by the actor 903 of the NTSC signal generation control system toward the object 1000 of the system B. At sequence number 2.1, an event "signal generation", which is a verified model element, is performed by the object 1000 of the system B toward the actor 907 of the NTSC signal input system. At sequence number 3, an event "terminate signal generation", which is a verified model element, is performed by the actor 903 of the NTSC signal generation control system toward the object 1000 of the system B.

The layout diagram shown in Fig. 11 represents a physical structure of the verified system B. As shown in Fig. 11, a node 1101 represents the NTSC signal pattern setting system; a node 1102 is a verified model element representing the NTSC signal generation control system; a node 1103 is a verified model element representing an NTSC signal output system, which is the system B; and a node 1104 is a verified model element representing the NTSC signal input system. A link 1105 is a verified model element representing a signal cable connecting the node 1101 and the node 1102; a link 1106 is a verified model element representing a signal cable connecting the node 1102 and the node 1103; and a link 1107 is a verified model element representing a signal cable connecting the node 1103 and the 1104;

Fig. 12 illustrates a verification policy 1201, verification items 1202, and a verification method for the NTSC signal output system, which is the system B. Fig. 13 illustrates cost information 1300 representing costs spent on the logic verification operation of the system B. Fig. 14 illustrates a verification environment 1400 when the logic verification operation of the system B was performed.

### (Functional Configuration of Verification Support Apparatus)

Description will be made of a functional configuration of the verification support apparatus according to the embodiment of the present invention. Fig. 15 is a block diagram showing a functional configuration of the verification support apparatus according to the embodiment of the present invention. As shown in Fig. 15, a verification support apparatus 1500 includes a storing unit 1501, an input unit 1502, a searching unit 1503, a logic-verification-content extracting unit 1504, and an output unit 1505.

The storing unit 1501 stores the UML describing a system verified by performing the logic verification, and the logic verification content thereof. The storing unit 1501 includes the verification asset database 200. The storing unit 1501 may be configured to be provided in the verification support apparatus 1500 and may be configured to be provided in a not-shown external server via the network 114 shown in Fig. 1, such as the internet, a LAN, a wide area network (WAN), etc. Specifically, for example, the function of the storing unit 1501 is realized by the ROM 102, the RAM 103, the HD 105, the FD 107, etc. shown in Fig. 1.

The input unit 1502 accepts input of an unverified specification description representing an unverified design object, which is described with unverified model elements. The unverified design object can be the unverified system X on which the logic verification has not been performed described above. The specification description can be the UML representing a function, a processing, a structure, etc. of a design object or a diagram represented by the UML. Specifically, for example, the specification description can be expressed by diagrams such as the use case diagram, the sequence diagram, and the layout diagram in the UML described above.

The model element is a diagram, a symbol, a word, a text, or a group thereof constituting the specification description for representing the design object, and if the UML is used for the specification description, the model element can represent an actor, a use case, a class, an object, an event, a guard condition, a node, a link, etc.

Description will be made of the unverified specification description input by the input unit 1502 with reference to Figs. 16 to 18. Fig. 16 is a use case diagram of the unverified system X; Fig. 17 is a sequence diagram of the unverified system X; and Fig. 18 is a layout diagram of the unverified system X.

The use case diagram shown in Fig. 16 represents functions of the system X. As shown in Fig. 16, an actor 1601 is a model element representing an NTSC image input apparatus, which is an external apparatus, and a use case 1602 is a model element describing a use case description "input NTSC image" in the system X. An actor 1603 is a model element representing a PAL image input apparatus, which is an external apparatus, and a use case 1604 is a model element describing a use case description "input PAL image" in the system X. A use case 1605 is a model element describing a use case description "write digital data" in the system X, and an actor 1606 is a model element representing an SCSI-HD apparatus, which is an external apparatus.

The sequence diagram shown in Fig. 17 represents data exchanges in the system X in chronological order. As shown in Fig. 17, at sequence number 1, an event "signal input" constituting a model element is performed by the actor 1601 of the NTSC image input apparatus toward an object 1700 of the system X. At sequence number 1.1, an event "convert into digital data (input signal)" constituting a model element is performed in the object 1700 of the system X. At sequence number 1.2, an event "output to SCSI-HD (digital data)" constituting a model element is performed by the object 1700 of the system X toward the actor 1606 of the SCSI-HD apparatus.

The layout diagram shown in Fig. 18 represents a physical structure of the system X. As shown in Fig. 18, a node 1801 is a model element representing the NTSC image input apparatus; a node 1802 is a model element representing the PAL image input apparatus; a node 1803 is a model element representing MPU; and a node 1804 is a model element representing the SCSI-HD apparatus. A link 1805 is a model element representing a bus connecting the node 1801 and the node 1803, and a link 1806 is a model element representing a bus connecting the node 1802 and the node 1803. A link 1807 is a model element representing a SCSI connecting the node 1803 and the node 1804.

As shown in Fig. 15, the searching unit 1503 searches a verified specification description identical or similar to the unverified specification description input by the input unit 1502 from the verified specification descriptions representing the verified design objects described with the verified model elements, based on the unverified model elements and the verified model elements. The identity, similarity, or non-similarity between the unverified specification description and the verified specification description can be represented by converting into a numerical value using the number of matches between the unverified model elements and the verified model elements, or a score for scoring the number of the matches. When the UML of an unused specification description is input, for example, if the UML is written in the form of a use case diagram, the searching unit 1503 can search the UML of a use case diagram identical or similar to the input use case diagram from the storing unit 1501. The internal mechanism of the searching unit 1503 will be described later.

The logic-verification-content extracting unit 1504 extracts content of the logic verification performed on the verified system searched by the searching unit 1503, that is, the verification policy 231, the verification item 232, the verification method 233, the cost information 234, and the verification environment 235 shown in Fig. 2 from the storing unit 1501. The output unit 1505 outputs the logic verification content extracted by the logic-verification-content extracting unit 1504. The functions of the input unit 1502, the searching unit 1503, the logic-verification-content extracting unit 1504, and the output unit 1505 are realized, specifically, by executing programs recorded on, for example, the ROM 102, the RAM 103, the HD 105, the FD 107 shown in Fig. 1, etc. with the CPU 101, or by the I/F 109.

Description will be made of the internal mechanism of the searching unit 1503. As shown in Fig. 15, the searching unit 1503 includes an unverified-model-element extracting unit 1511, a verified-model-element extracting unit 1512, a processing unit 1513, and a similarity calculating unit 1514.

The unverified-model-element extracting unit 1511 extracts the unverified model element from the unverified specification description input by the input unit 1502. For example, when the use case diagram shown in Fig. 16 is input, the unverified-model-element extracting unit 1511 extracts an unverified model element X1 "input NTSC image", an unverified model element X2 "input PAL image", and an unverified model element X3 "write digital data", which are the use case descriptions described in this use case diagram.

The verified-model-element extracting unit 1512 extracts the verified model element from the verified specification description stored in the storing unit 1501 when the unverified specification description is input by the input unit 1502. For example, in the case of the verified system A, when the use case diagram is input to the input unit 1502, the verified-model-element extracting unit 1512 extracts an unverified model element A1 "input digital data", which is the use case description shown in Fig.3, and an unverified model element A2 "write digital data", which is the use case description. The extraction of the verified model element can be performed for all the verified specification descriptions stored in the storing unit 1501.

The processing unit 1513 processes each of the unverified model element and the verified model element. The processing unit 1513 includes a disassembling unit 1515 and a group generating unit 1516. The disassembling unit 1515 performs disassembly when the input UML is a use case diagram. The group generating unit 1516 generates an event group or a layout group described later when the input UML is a sequence diagram or a layout diagram.

The disassembling unit 1515 disassembles each of a use case description of a text indicating the unverified model element extracted by the unverified-model-element extracting unit 1511 and a use case description of a text indicating the verified model element extracted by the verified-model-element extracting unit 1512 into words. In the words obtained by the disassembling unit 1515, only nouns and verbs are utilized, and words indicating particles such as "ga", "ha", "ni", "he", "wo", etc. are erased. Fig. 19 is an explanatory diagram showing an example of disassembling texts indicating the unverified model elements, and Fig. 20 is an explanatory diagram showing an example of disassembling texts indicating verified model elements.

As shown in Fig. 19, for example, in the case of the unverified model element X1 "input NTSC image", the disassembling unit 1515 divides this text into words and disassembles the text into "NTSC image", "(wo)", and "input". A word "wo" is erased because the word is a particle, and "NTSC image" and "input" are used. As shown in Fig. 20, in the case of the verified model element A1 "input digital data", the disassembling unit 1515 divides this text into words and disassembles the text into "digital data", "(wo)", and "input". A word "wo" is erased because the word is a particle, and "digital data" and "input" are used. The disassembled words can be weighted by a weight setting unit 1517. For example, by giving a basic score "+1" to the word "input", a word desired to be focused may be weighted.

When an unverified sequence diagram is input, the group generating unit 1516 generates an event group from events indicating the unverified model elements extracted by the unverified-model-element extracting unit 1511. Similarly, the group generating unit 1516 generates an event group from events showing the verified model elements extracted by the verified-model-element extracting unit 1512. A specific example of the event group will be described later.

When an unverified layout diagram is input, the group generating unit 1516 generates a layout group from the nodes and the links indicating the unverified model elements extracted by the unverified-model-element extracting unit 1511. Similarly, the group generating unit 1516 generates a layout group from the nodes and the links indicating the verified model elements extracted by the verified-model-element extracting unit 1512. A specific example of the layout group will also be described later.

The similarity calculating unit 1514 calculates a similarity between the unverified model element extracted by the unverified-model-element extracting unit 1511 and the verified model element extracted by the verified-model-element extracting unit 1512. Specifically, the similarity calculating unit 1514 includes a comparing unit 1518 and a score calculating unit 1519.

The comparing unit 1518 compares the unverified model element extracted by the unverified-model-element extracting unit 1511 and the verified model element extracted by the verified-model-element extracting unit 1512. Specifically, when an UML use case diagram is input by the input unit 1502, the comparison is performed based on the words obtained by the disassembling unit 1515. For example, when comparing the unverified model element X1 shown in Fig. 19 and the verified model element A1 shown in Fig. 20, the word "NTSC image" of the unverified model element X1 is not identical to the word "digital data" in the verified model element A1. On the other hand, the word "input" of the unverified model element X1 is identical to the word "input" in the verified model element A1. In this case, a part of the model elements X1, and A1 are identical. When comparing the unverified model element X3 and the verified model element A2, the word "digital data" of the unverified model element X3 is identical to the word "digital data" in the verified model element A2. Similarly, the word "write" of the use case description X3 is identical to the word "write" in the verified model element A1. In this case, the model elements X3, and A2 are completely identical.

The score calculating unit 1519 calculates a score representing the similarity between the unverified model element and the verified model element based on the result of the comparison performed by the comparing unit 1518. Fig. 21 is a chart showing a relationship between score conditions when words are compared, and basic scores and associated scores in those cases. The basic score is a score added or multiplied when comparing the unverified model element and the verified model element. The associated score is a score additionally added when a certain condition is satisfied in the comparison by the comparing unit 1518. The score represents a degree of similarity to an unverified system for each verified system, and a designer can determine that the systems are not similar when the score is a predetermined value or less and that the systems are similar when the score is greater than the predetermined value. In the scores of the verified systems, the systems ranked in the top k can be determined to be similar and the systems ranked at k+1 or lower can be determined to be not similar. The verified system with the highest score is most similar to the unverified system.

Description will be made of a relationship between the verified system compared with the unverified system X and the scores. Fig. 22 is an explanatory diagram showing a relationship between the verified system A compared with the unverified system X and the scores. Fig. 23 is an explanatory diagram showing a relationship between the verified system B compared with the unverified system X and the scores.

Referring to Figs. 22 and 23, each of verified model elements A1 and A2, and B1 to B4 is compared with each of the unverified model elements X1 to X3 to obtain a score calculated by the score calculating unit 1519.

For example, with regard to the verified model element A1 shown in Fig. 22, when compared with the unverified model element X1, the word "digital data" of the verified model element A1 is identical to the word "digital data" of the unverified model element X1, which corresponds to "when word is identical" shown in Fig. 21, and the basic score "1" is added. On the other hand, since the word is not identical to the words of the unverified model elements X2 and X3, the basic score is not added. Therefore, the basic score of the word "digital data" of the verified model element A1 is "1".

With regard to the verified model element A1 shown in Fig. 22, when compared with the unverified model element X1, the word "input" of the verified model element A1 is identical to the word "input" of the unverified model element X1, which corresponds to "when word is identical" in the chart shown in Fig. 21, and the basic score "1" is added. Similarly, when compared with the unverified model element X2, the word "input" of the verified model element A1 is identical to the word "input" of the unverified model element X1, which corresponds to "when word is identical" shown in Fig. 22, and the basic score "1" is added. On the other hand, since the word is not identical to the words of the unverified model element X3, the basic score is not added. Therefore, the basic score of the word "input" of the verified model element A1 is "2".

Since the verified model element A1 does not satisfy the score condition for adding the associated score shown in Fig. 21, the associated score is "0". Therefore, a score subtotal of the basic score and the associated score is "3".

With regard to the verified model element A2 shown in Fig. 22, when compared with the unverified model element X3, the word "digital data" of the verified model element A2 is identical to the word "digital data" of the unverified model element X3, which corresponds to "when word is identical" in the chart shown in Fig. 21, and the basic score "1" is added. Similarly, the word "write" of the verified model element A2 is identical to the word "write" of the unverified model element X3, which corresponds to "when word is identical" shown in the chart of Fig. 21, and the basic score "1" is added.

Since the verified model element A2 satisfies the score condition "when all words in one unverified model element are identical" for adding the associated score shown in Fig. 21, the associated score can be added. Since the total number of the words is n=2, the associated number to be added is "2". Therefore, for the verified model element A2, a score subtotal of the basic score and the associated score is "4".

Thus, the score indicating the similarity of the verified system A to the unverified system X is a total value of the score subtotal values of the verified model elements A1 and A2, which is "7".

If the verified model elements B1 to B4 shown in Fig. 23 are compared with the unverified model elements X1 and X2, since no word is identical, the score conditions in the chart shown in Fig. 21 are not satisfied. Therefore, the score indicating the similarity of the verified system B to the unverified system X is "0".

Description will be made of a relationship between the unverified system X and the verified systems A and B. Fig. 24 is an explanatory diagram showing a relationship between the unverified system X and the verified systems A and B. A thin lines for connecting the unverified system X and the verified systems A and B shown in Fig. 24 indicate that the unverified model element and the verified model element are partially identical, and a thick line indicates that the unverified model element and the verified model element are completely identical. In an example shown in Fig. 24, although the unverified model elements X1 to X3 are partially identical to the verified model element A1, therefore, linked with the thin lines to the verified model element A1, the associated score is "0" because the model elements are not completely identical. On the other hand, since the unverified model element X3 and the verified model element A2 are completely identical, the associated score is "2" as shown in Fig. 21.

On the other hand, since the unverified model elements X1 to X3 are not identical to any of the verified model elements B1 to B4, the unverified model elements X1 to X3 are not linked with the thick line nor the thin line. Therefore, it is found also from this figure that the system B has the score indicating the similarity of "0" and is not similar to the system X.

Description will be made of a search-result display example according to the embodiment of the verification support apparatus of the present invention. Fig. 25 is an explanatory diagram showing a search-result display example according to the embodiment of the verification support apparatus of the present invention. A search screen 2500 as shown in Fig. 25 is displayed on the display shown in Fig. 1. The search screen 2500 can be output also by the printer 113. The search screen 2500 has a frame 2501, a frame 2502, and a frame 2503. The frame 2501 displays a search result, which is a name of the searched system with the highest score indicating the similarity and the score thereof. The frame 2502 displays a search result list 2504. In the search result list, names of the verified systems are displayed in the order of descending scores indicating the similarity. The frame 2503 displays a search result, which is a verification policy 2505, a verification item 2506, a verification method 2507, cost information 2508, and a verification environment 2509 of the searched system having the highest score indicating the similarity.

Description will be made of an example when the use case diagram of the verified system is identical and when the sequence diagram and the layout diagram are different. Fig. 26 is a sequence diagram of a verified system C, and Fig. 27 is a layout diagram of the verified system C. A use case diagram of this verified system C is identical to the use case diagram of the verified system A shown in Fig. 3 and omitted.

The sequence diagram shown in Fig. 26 represents data exchanges in the verified system C in chronological order. As shown in Fig. 26, at sequence number 1, an event "data input (digital data)" constituting a verified model element is performed by the actor 301 of the digital data input apparatus toward an object 2601 of a control application specific integrated circuit (ASIC). At sequence number 1.1, an event "write (digital data)" constituting a verified model element is performed by the object 2601 of the control ASIC toward an object 2602 of a RAM. At sequence number 1.2, an event "read ()" constituting a verified model element is performed by the object 2601 of the control ASIC toward the object 2602 of the RAM. A guard condition at this point is [RAM is FULL]. At sequence number 1.3, an event "write to SCSI (digital data)" constituting a verified model element is performed by the object 2601 of the control ASIC toward an object 2603 of a SCSI-controller. A guard condition at this point is [RAM is FULL]. At sequence number 1.3.1, an event "output to SCSI-HD (digital data)" constituting a verified model element is performed by the object 2603 of the SCSI-controller toward the actor 304 of a SCSI-HD apparatus.

The layout diagram shown in Fig. 27 represents a physical structure of the system C. As shown in Fig. 27, a node 2701 is a verified model element representing the control ASIC; a node 2702 is a verified model element representing the RAM; and a node 2703 is a verified model element representing the SCSI-controller. A link 2704 is a verified model element representing a control interface connecting the node 501 and the node 2702; a link 2705 is a verified model element representing a RAM interface connecting the node 2701 and the node 2702; a link 2706 is a verified model element representing a SCSI control interface coupling the node 2701 and the node 2703; and a link 2707 is a verified model element representing a SCSI connecting the node 2703 and the node 503.

Description will be made of a relationship with the verified model elements of the verified systems A and C, and the scores thereof when the description content of the specification description of the unverified system X is the UML sequence diagram. Fig. 28 is an explanatory diagram showing a verified event group of the unverified system X when the specification description of the unverified system X is the UML sequence diagram; Fig. 29 is an explanatory diagram showing a relationship with the verified model element of the verified system A and the score thereof; and Fig. 30 is an explanatory diagram showing a relationship with the verified model elements of the verified system C and the scores thereof.

An unverified model element group X11 shown in Fig. 28 is an event group combining the event "signal input" at sequence number 1 and the event "convert into digital data (input signal)" at sequence number 1.1 shown in Fig. 17. An unverified model element group X12 is an event group combining the event "convert into digital data (input signal)" at sequence number 1.1 and the event "output to SCSI-HD (digital data)" at sequence number 1.2.

A verified model element group A11 shown in Fig. 29 is an event group combining the event "data input (digital data)" at sequence number 1 and the event "output to SCSI-HD (digital data)" at sequence number 1.1 shown in Fig. 4. When comparing the verified model element group All and the an verified model element group X11, as shown in Fig. 21, since only the event "output to SCSI-HD (digital data)" is identical: the basic score is "1", the associated score is "0"; and the total score is "1". When comparing the verified model element groups C11 to C14 and the unverified model element group X11, as shown in Fig. 21, the subtotal scores are "0" for the verified model element groups C11 to C13, and since only the event "output to SCSI-HD (digital data)" is identical and the guard condition "[RAM is FILL]" is present for the event group C14: the basic score is "0.5"; the associated score is "0"; and the subtotal score is "0.5". Therefore, the total score for the verified system C is "0.5". Thus, with regard to the data flow in the system, it is found that the verified system C is more similar to the system X than the verified system A.

Description will be made of a relationship with the verified model elements of the verified systems A and C, and the scores thereof when the description content of the specification description of the unverified system X is the UML layout diagram. Fig. 31 is an explanatory diagram showing the verified model element groups of the unverified system X when the specification description of the unverified system X is the UML layout diagram; Fig. 32 is an explanatory diagram showing a relationship with the verified model elements of the verified system A and the scores thereof; and Fig. 33 is an explanatory diagram showing a relationship with the verified model elements of the verified system C and the scores thereof.

Unverified model element groups shown in Fig. 31 are layout groups and are model element groups combining the nodes and the links connected in the layout diagram shown in Fig. 5. An unverified model element group X21 is a layout group combining the node 1801 and the link 1805 shown in Fig. 18; an unverified model element group X22 is a layout group combining the node 1802 and the link 1806 shown in Fig. 18; an unverified model element group X23 is a layout group combining the node 1803 and the link 1807 shown in Fig. 18; and an unverified model element group X24 is a layout group combining the link 1807 and the node 1804 shown in Fig. 18.

Referring to Fig. 32, a verified model element group A21 of the verified system A is a layout group combining the node 501 and the link 504 shown in Fig. 5; a verified model element group A22 is a layout group combining the node 502 and the link 505 shown in Fig. 5; and a verified model element group A23 is a layout group combining the node 505 and the link 503 shown in Fig. 5.

When comparing the verified model element groups A21 to A24 of the system A with the unverified model element groups X21 to X25 of the system X shown in Fig. 31, since the verified model element group A21 is not identical to any of the unverified model element groups X21 to X25, the basic score is "0".

Since the verified model element group A22 is identical to the unverified element group X23, the basic score is "1". Since the verified model element group A23 is identical to the unverified element group X24, the basic score is "1". Since the verified model element group A24 is identical to the unverified element group X25, the basic score is "1". Therefore, the total score of the verified system A is "3".

Referring to Fig. 33, a verified model element group C21 of the verified system C is a layout group combining the node 501 and the link 2704 shown in Fig. 27; a verified model element group C22 is a layout group combining the link 2704 and the node 2701 shown in Fig. 27; a verified model element group C23 is a layout group combining the node 2701 and the link 2705 shown in Fig. 27; a verified model element group C24 is a layout group combining the link 2705 and the node 2702 shown in Fig. 27; a verified model element group C25 is a layout group combining the node 2701 and the link 2706 shown in Fig. 27; a verified model element group C26 is a layout group combining the link 2706 and the node 2703 shown in Fig. 27; a verified model element group C27 is a layout group combining the node 2703 and the link 2707 shown in Fig. 27; and a verified model element group C28 is a layout group combining the link 2707 and the node 503 shown in Fig. 27.

When comparing the verified model element groups C21 to C28 of the system C with the unverified model element groups X21 to X25 of the system X shown in Fig. 31, since the verified model element groups C21 to C27 are not identical to any of the unverified model element groups X21 to X25, the basic score is "0". On the other hand, since the verified model element group C28 is identical to the unverified model element group X25, the basic score is "1". Therefore, the total score of the verified system C is "1". Thus, with regard to the hardware configuration of the system, the verified system A is more similar to the system X than the unverified system C.

### (Verification Support Processing of Verification Support Apparatus)

Description will be made of a verification support processing by the verification support apparatus according to the embodiment of the present invention. Figs. 34 to 37 are flowcharts showing the verification support processing by the verification support apparatus according to the embodiment of the present invention. As shown in Fig. 34, if the UML of the unverified system is input (step S3401: YES), it is determined whether the input UML is the use case diagram (step S3402). If the UML is not the use case diagram (step S3402: NO), it is determined whether the input UML is the sequence diagram (step S3403). If the UML is not the sequence diagram (step S3403: NO), it is determined whether the input UML is the layout diagram (step S3404). If the UML is not the layout diagram (step S3404: NO), the procedure goes back to step S3402.

If the input UML is the use case diagram (step S3402: YES), as shown in Fig. 35, the unverified model elements are extracted from the input use case diagram (step S3501). The texts showing the extracted unverified model elements are disassembled by the disassembling unit 1515 into words (step S3502), and i=1 is established (step S3503). It is searched in the storing unit 1501 whether the use case diagram of the i-th verified system is present (step S3504). If the use case diagram is not present (step S3504: NO), i is incremented by one (step S3505) and the procedure goes back to step S3504.

If the use case diagram of the i-th verified system is present (step S3504: YES), the use case diagram of the i-th verified system is extracted from the storing unit 1501 (step S3506). The verified model elements are extracted from the extracted use case diagram (step S3507), and the texts thereof are disassembled into words (step S3508).

The unverified model elements are compared with the verified model elements (step S3509). The comparison is performed between the words obtained by disassembling. Based on the comparison result, a score of the i-th verified system is calculated (step S3510). If i is not equal to the total number N of the verified systems stored in the storing unit 1501 (step S3511: NO), i is incremented by one (step S3512) and the procedure goes back to step S3504.

On the other hand, if i is equal to the total number N of the verified systems stored in the storing unit 1501 (step S3511: YES), the logic verification content of the verified system having the highest score is extracted from the storing unit 1501 (step S3513). The extracted logic verification content is output (step S3514) and displayed on the display 108.

If the input UML is the sequence diagram (step S3403: YES) in Fig. 34, the unverified model elements are extracted from the input sequence diagram (step S3601) as shown in Fig. 36. One event group is formed from unverified model elements with consecutive sequence numbers (step S3602) and i=1 is established (step S3603). It is searched in the storing unit 1501 whether the sequence diagram of the i-th verified system is present (step S3604). If the sequence diagram is not present (step S3604: NO), i is incremented by one (step S3605) and the procedure goes back to step S3604.

If the sequence diagram of the i-th verified system is present (step S3604: YES), the sequence diagram of the i-th verified system is extracted from the storing unit 1501 (step S3606). The verified model elements are extracted from the extracted sequence diagram (step S3607), and one event group is formed from the verified model elements with consecutive sequence numbers (step S3608).

The unverified model elements and the verified model elements forming the event groups are compared (step S3609). Based on the comparison result, a score of the i-th verified system is calculated (step S3610). If i is not equal to the total number N of the verified systems stored in the storing unit 1501 (step S3611: NO), i is incremented by one (step S3612, and the procedure goes back to step S3604.

On the other hand, If i is equal to the total number N of the verified systems stored in the storing unit 1501 (step S3611: YES), the logic verification content of the verified system having the highest score is extracted from the storing unit 1501 (step S3613). The extracted logic verification content is output (step S3614) and displayed on the display 108.

If the input UML is the layout diagram (step S3404: YES) in Fig. 34, the unverified model elements are extracted from the input layout diagram (step S3701) as shown in Fig. 37. One layout group is formed from the unverified model element groups with consecutive sequence numbers (step S3702), and i=1 is established (step S3703). It is searched in the storing unit 1501 whether the layout diagram of the i-th verified system is present (step S3704). If the layout diagram is not present (step S3704: NO), i is incremented by one (step S3705), and the procedure goes back to step S3704.

If the layout diagram of the i-th verified system is present (step S3704: YES), the layout diagram of the i-th verified system is extracted from the storing unit 1501 (step S3706). The nodes and links constituting the verified model elements are extracted from the extracted layout diagram (step S3707), and one layout group is formed from the consecutive connected nodes and links (step S3708).

The unverified model elements and the verified model elements forming the layout groups are compared (step S3709). Based on the comparison result, a score of the i-th verified system is calculated (step S3710). If i is not equal to the total number N of the verified systems stored in the storing unit 1501 (step S3711: NO), i is incremented by one (step S3712), and the procedure goes back to step S3704.

On the other hand, if i is equal to the total number N of the verified systems stored in the storing unit 1501 (step S3711: YES), the logic verification content of the verified system having the highest score is extracted from the storing unit 1501 (step S3713). The extracted logic verification content is output (step S3714) and displayed on the display 108.

Thus, in accordance with the input UML diagrams, the similarity between the unverified UML and the verified UML can be calculated by converting into a score, and the content of the logic verification performed for the verified system having the highest similarity can be offered to the designer.

Although the UML description of the specification description is described using the use case diagrams, the sequence diagrams, and the layout diagrams in the above embodiment, class diagrams, object diagrams, collaboration diagrams, state chart diagrams, activity diagrams, package diagrams, or component diagrams may also be used.

Although the verified specification description and the logic verification content thereof are stored in the storing unit 1501 in the above embodiment, unverified common specific description and logic verification content thereof may be stored. When an unverified design object is input, the name thereof may be input.

As described above, according to the verification support apparatus of the embodiment, the costs of the logic verification performed on the system to be designed can be reduced. Consequently, the loss that is caused when the cost estimation of the logic verification is incorrect can also be reduced. Therefore, with the reduction of the costs and loss of the logic verification, inexpensive LSI can be supplied to the market.

Since it is not necessary for the designer does to perform all the cost estimation required for the logic verification operation, the burden on the designer can be reduced, and therefore, the labor and the working period of the logic verification operation can be reduced.

The logic verification content stored in each section can be shared among sections. Therefore, the design assets can be diverted, and the labor and the working period of the logic verification operation can be reduced.

While in a conventional practice, a skilled worker such as a section leader performs the estimation of the logic verification costs, with this verification support apparatus, also an individual other than the skilled worker can easily perform the estimation of the logic verification costs.

The verification support method described in the embodiment can be achieved by executing a program prepared in advance with a computer such as a personal computer and a workstation. The program is recorded on a computer-readable recording medium, such as a HD, an FD, a CD-ROM, an MO, and a DVD, and is read from the recording medium by the computer for execution. The program may be a transmission medium that can be distributed through network such as the internet.

As described above, according to the present invention, the verified design object can be identified which is designed in accordance with the specification description approximated to the specification description of the unverified design object, and the content of the logic verification performed on the verified design object can be obtained. Thus, the costs of the logic verification operation can be reduced and the operation time can be shortened.

### INDUSTRIAL APPLICABILITY

As described above, the present invention is suitable for providing a verification support apparatus, a verification support method, a verification support program, and a recording medium that stores the program for supporting verification of a system constituted by hardware or software.

## Claims

1. A verification support apparatus, comprising:
an input unit configured to accept input of an unverified specification description representing an unverified design object constituted by unverified model elements;
a searching unit configured to search, from verified specification descriptions representing verified design objects constituted by verified model elements, a verified specification description identical or similar to the unverified specification description input to the input unit, based on the unverified model elements and the verified model elements;
a logic-verification-content extracting unit configured to extract contents of logic verification performed on the verified design object, based on a result of search by the searching unit; and
an output unit configured to output the contents of the logic verification extracted by the logic-verification-content extracting unit.

2. The verification support apparatus according to claim 1, wherein
the searching unit includes
an unverified-model-element extracting unit configured to extract the unverified model elements;
a verified-model-element extracting unit configured to extract the verified model elements; and
a similarity calculating unit configured to calculate a similarity between the unverified model element extracted by the unverified-model-element extracting unit and the verified model element extracted by the verified-model-element extracting unit, and
the logic-verification-content extracting unit is configured to extract the contents of the logic verification performed on the verified design object based on the similarity calculated by the similarity calculating unit.

3. The verification support apparatus according to claim 2, wherein
the similarity calculating unit includes
a comparing unit configured to compare a text expressing the unverified model element extracted by the unverified-model-element extracting unit and a text expressing the verified model element extracted by the verified-model-element extracting unit; and
a score calculating unit configured to calculate a score representing the similarity based on a result of comparison by the comparing unit, and
the logic-verification-content extracting unit is configured to extract the contents of the logic verification performed on the verified design object, based on the score calculated by the score calculating unit.

4. The verification support apparatus according to claim 3, wherein
the similarity calculating unit further includes a disassembling unit configured to disassemble each of the text expressing the unverified model element extracted by the unverified-model-element extracting unit and the text expressing the verified model element extracted by the verified-model-element extracting unit into words, and
the comparing unit is configured to compare the text expressing the unverified model element extracted by the unverified-model-element extracting unit and the text expressing the verified model element extracted by the verified-model-element extracting unit, based on the words obtained by disassembling by the disassembling unit.

5. The verification support apparatus according to claim 4, further comprising a weight setting unit configured to weight the words obtained by disassembling the text expressing the unverified model element by the disassembling unit, wherein
the score calculating unit is configured to calculate the score representing the similarity based on the result of comparison by the comparing unit and the weight of the word weighted by the weight setting unit.

6. The verification support apparatus according to claim 1, wherein the unverified specification description representing the unverified design object and the verified specification description representing the verified design object are described in a unified modeling language.

7. The verification support apparatus according to claim 1, wherein the contents of the logic verification includes at least any one of a logic verification policy, an item of the logic verification, a logic verification method, information on cost required for the logic verification, and a tool used when the logic verification is performed on the verified design object.

8. A verification support method, comprising:
inputting an unverified specification description representing an unverified design object described with unverified model elements;
searching, from verified specification descriptions representing verified design objects described with verified model elements, a verified specification description identical or similar to the unverified specification description input at the inputting, based on the unverified model elements and the verified model elements;
extracting contents of logic verification performed on the verified design object, based on a result of search at the searching; and
outputting the contents of the logic verification extracted by the logic-verification-content extracting unit.

9. A verification support program that makes a computer execute:
inputting an unverified specification description representing an unverified design object described with unverified model elements;
searching, from verified specification descriptions representing verified design objects described with verified model elements, a verified specification description identical or similar to the unverified specification description input at the inputting, based on the unverified model elements and the verified model elements;
extracting contents of logic verification performed on the verified design object, based on a result of search at the searching; and
outputting the contents of the logic verification extracted by the logic-verification-content extracting unit.

10. A computer-readable recording medium that records the verification support program according to claim 9.
